# EUROPEAN PATENT SPECIFICATION

(11) **EP 2 669 952 B1**
(45) Date of publication and mention of the grant of the patent: **25.03.2015**
(21) Application number: 12004216.3
(22) Date of filing: 01.06.2012
(51) Int. Cl.: H01L 31/0224, H01L 31/072, H01L 31/18, H01L 31/075

(54) **Photovoltaic device and method of manufacturing same**
Photovoltaische Vorrichtung und Verfahren zu ihrer Herstellung
Dispositif photovoltaïque et son procédé de fabrication

(43) Date of publication of application: 04.12.2013
(73) Proprietor: Roth & Rau AG, 09337 Hohenstein-Ernstthal (DE)
(72) Inventor: Lachenal, Damien, 2022 Bevaix (CH); Wahli, Guillaume, 1024 Ecublens (CH); Meixenberger, Jérôme, 2068 Hauterive (CH); Strahm, Benjamin, 1429 Giez (CH); Barraud, Loris, 2300 La Chaux-de-Fonds (CH)
(74) Representative: Steiniger, Carmen

(56) References cited:
- EP-A1- 2 416 370
- US-A1- 2009 084 439
- US-A1- 2009 126 791
- US-A1- 2010 089 444
- US-A1- 2011 186 120
- US-A1- 2011 303 278
- US-A1- 2011 315 214

## Description

The present invention relates to a photovoltaic device, in particular a solar cell, with a hetero-junction comprising a crystalline semiconductor body; a front passivation layer formed on a front surface of the semiconductor body; an emitter or a front surface field layer formed on the front passivation layer; a front-sided transparent conductive material stack; and a front grid metallization. The invention further relates to a method of manufacturing a photovoltaic device, in particular of a solar cell, using the following steps: providing a crystalline semiconductor body; forming a front passivation layer on the semiconductor body; forming an emitter or a front surface field layer on the front passivation layer; forming a front-sided transparent conductive material stack; and forming a front grid metallization.

In the last two decades, silicon hetero-junction solar cells have gained much interest due to their high energy conversion efficiencies and simple fabrication.

A silicon hetero-junction solar cell is based on a crystalline semiconductor body such as an n-type silicon wafer. In conventional hetero-junction solar cells, the crystalline semiconductor body is sandwiched between an emitter on the front side and a back surface field layer on the back side of the hetero-junction solar cell. These layers are several nanometers thin and are usually deposited by plasma-enhanced chemical vapor deposition (PE-CVD). Since in most hetero-junction cells the semiconductor body is of n-type, the emitter at the front of a silicon hetero-junction device is of p-type, whereas the back surface field layer is n-type. Furthermore, a first passivation layer is inserted between the crystalline semiconductor body and the emitter. A second passivation layer is inserted between the crystalline semiconductor body and the back surface field layer. The goal of these passivation layers is to reduce the density of surface states at the surface of the crystalline semiconductor body. Favorably, as passivation layers intrinsic layers are used. This structure provides favorable surface passivation characteristics and high open-circuit voltages (V_{oc}) of solar cells. Finally, the back side of the silicon hetero-junction solar cell is coated with a transparent conductive material (TCM) layer and a metallic contacting layer while the front side of the hetero-junction solar cell is coated with a TCM layer acting as a protective layer, as an antireflection coating and as a conductive film in order to extract laterally the current to the front grid metallization provided on the front side of the hetero-junction solar cell.

Moreover, there exist hetero-junction solar cells with an inverted structure, so-called flip-flop cells, where the emitter is placed on the back-side of the solar cell, that means, in the direction of the incident light behind the crystalline semiconductor body in order to avoid a loss of efficiency induced by light absorption of the emitter. In these hetero-junction solar cells which are also part of the present invention, on the front-side of the solar cell a front surface field layer is provided, wherein the type of doping of the front surface field layer corresponds to the type of doping of the crystalline semiconductor body of the respective solar cell. The type of doping of the emitter arranged on the back side of these solar cells is contrary to the type of doping of the crystalline semiconductor body.

The key point of hetero-junction solar cells is the displacement of highly recombination-active (ohmic) contacts from the silicon surface by insertion of a film with wide bandgap. Practically, amorphous hydrogenated silicon (a-Si:H) films have proven to be appealing candidates for this: their bandgap is wider than that of crystalline silicon (c-Si), and such films can reduce the c-Si surface state density by hydrogenation, this allows for a (lithography-free) fabrication of contacts with low values for the saturation-current density.

In the state of the art, the front transparent conductive oxide (TCO) layer of hetero-junction solar cells is typically indium tin oxide (ITO). Sputtered ITO has typical electron mobility, free electron concentration values and resistivities of µ = 20 to 40 cm²/Vs, nₑ = 10¹⁹ to 10²¹ cm⁻³, and p = 10⁻⁴ to 10⁻² Ωcm depending on thickness and film composition. Due to the relatively low electron mobility of the ITO, the carrier concentration needed to achieve a good resistivity should be high, therefore leading to a strong absorption of the ITO film limiting the short circuit current of the hetero-junction solar cell.

In summary, the known hetero-junction solar cells suffer from a low short-circuit current density due to the compromise between transparency and resistivity required in the TCM layer.

Besides, from the document US 2011/0194181 A1, the use of two laminated indium oxide-based thin films forming a double layer antireflection coating of a solar cell is known. Both layers show antireflective properties. To fulfill the antireflection coating requirements by the double layer, the refractive index of the additional antireflection layer has to match the refractive index of the layer underneath. As indium oxide-based material, In₂O₃-SnO₂, In₂O₃-TiO₂ or In₂O₃-ZnO can be used. The laminated indium oxide-based thin films have different refractive indices resulting from a variation of composition of the reactive gas used during sputtering of the respective layer. By the lamination of thin films of the same base-material but with different refractive indices, an antireflection film with a desired antireflection performance shall be producible in one sputtering device. The desired antireflection performance is obtained by changing the thickness and process dependent refractive indices of the high refractive index layer and the low refractive index layer. Furthermore, lowering of the resistance of the indium oxide-based thin films is realized by an increase of the thickness of the corresponding thin film. In an embodiment, the refractive indices of the laminated indium oxide-based thin films become successively smaller heading outward of the structure, that means, the upper indium oxide-based thin film has a lower refractive index (for example n = 1,96) than the lower indium oxide-based thin film (for example n = 2,25) of the double layer antireflection coating.

A solar cell comprising a TCO stack with two sub-layers is also known from US 2011/0303278 A1. To ensure good ohmic contact with low contact resistance the sub-layer on top of the emitter is formed using a high work function TCO material.

It is the object of the present invention to provide a photovoltaic device and a method of manufacturing same, leading to a decrease of optical and electrical losses in hetero-junction solar cells caused by the transparent conductive material (TCM).

The object is solved by a photovoltaic device of the above mentioned type wherein the front-sided transparent conductive material (TCM) comprises a stack of at least two transparent conductive components having different compositions. According to the invention, the front-sided transparent conductive material stack comprises: a front-sided first transparent conductive layer consisting of a first base material with a first doping and having a non-stoichiometric composition with a first deviation from stoichiometry, wherein the first base material is chosen from the group of materials including indium oxide, zinc oxide, tin oxide, and cadmium oxide; and a front-sided second transparent conductive layer or structure consisting of the first base material or a second base material, said first or second base material having the first doping or a second doping being different from the first doping and having a non-stoichiometric composition, wherein the composition of the second base material is different from the composition of the first base material and wherein the composition of the first base material has a second deviation from stoichiometry being different from the first deviation from stoichiometry, respectively. Furthermore, the average carrier concentration of the whole front-sided transparent conductive material stack is between 1 x 10²⁰ cm⁻³ and 2 x 10²⁰ cm⁻³; the refractive indices (n) of the front-sided first transparent conductive layer and of the front-sided second transparent conductive layer or structure are in the same range, wherein n > 2 at a wavelength of about 550 nm; and the carrier mobility in the front-sided first transparent conductive layer is higher than the carrier mobility in the front-sided second transparent conductive layer or structure if the layers/structure have a comparable thickness.

Preferably, but not necessarily, the first and the second transparent conductive layer/structure have a different doping. The different doping of the layers or structure of the transparent conductive material stack can be achieved by different dopant material and/or different dopant material concentrations.

In the invention, standard transparent conductive material layer, such as ITO, is replaced with a combination of at least two transparent conductive components forming the transparent conductive material stack. That means, the invention solves the object by distributing the features to reach with the TCM layer to several TCM films/structures, wherein one of these layers/structures has another composition, in particular another composition or deviation from stoichiometry, than the other layer/structure of the transparent conductive material stack. In other words, the TCM used in the present invention is split into a TCM stack of at least two different TCM layers/structures being superposed and having different compositions and thus different resistivities and transparencies. This way, the transparent conductive layer/structure with the higher doping and/or with the higher carrier density can be used to provide a good electrical contact between the transparent conductive material and the fingers of the front grid metallization, whereas the transparent conductive layer/structure with the lower doping and/or with the lower carrier density and higher carrier mobility allows for good optical features of the solar cell, since lower doping leads to better transparency and carrier mobility. As these features are combined in the TCM stack used in the present invention, a photovoltaic device with a high efficiency can be provided.

The transparent conductive layers/structures of the transparent conductive material stack are two or more layers or structures stacked on each other. These layers or structures of the transparent conductive material stack can be of different materials, but can also be of the same base-material but with different deviations from the stoichiometry and/or different additives. The layers or structures of the transparent conductive material stack can also have different thicknesses.

Although the layers or structures of the transparent conductive material stack have different compositions or different deviations from stoichiometry and, preferably, different doping, the materials and doping of these layers or structures are chosen and/or deposited in such a way that their refractive indices are in the same range with n > 2 at a wavelength of about 550 nm resulting in an optically unique layer stack. That means, the whole transparent conductive material stack forms a unique antireflection coating, although its components (layers or structures of the transparent conductive material stack) have different electrical properties.

In the present invention, the optical features of the layers and structures of the transparent conductive material stack are defined by the materials and the doping used. This kind of definition of the optical features of the layers is very precise and directly connected with a precise definition of the electrical parameters of the layers or structures of the transparent conductive material stack.

These optical and electrical features of the transparent conductive material stack are especially important on the front side of the solar cell of the present invention, where is the incidence of light into the solar cell as well as an electrical connection of the emitter by the front grid metallization.

It has been shown to be especially favorable, if the front-sided first transparent conductive layer consists of a material with a first transparency and a first resistivity and if the front-sided second transparent conductive structure consists of a material with a second transparency and a second resistivity, wherein the first transparency is higher than the second transparency and the second resistivity is lower than the first resistivity. This transparent conductive material (TCM) stack allows increasing the current density with a highly transparent TCM as well as decreasing the contact resistance with the front metallization grid by the use of a highly conductive TCM.

In a common example of the invention, the crystalline semiconductor body is of n-type and the emitter on the front side of the photovoltaic device is of p-type, since most conventional silicon hetero-junction solar cells are of this structure. Besides, it is also possible to use the invention on hetero-junction solar cells with a semiconductor body of p-type and an emitter of n-type. Alternatively, it is also possible to use the invention on hetero-junction solar cells with a crystalline semiconductor body of respectively n-type (p-type) and a front-side surface field layer of n-type (p-type).

According to a beneficial embodiment of the invention, the above mentioned advantages of the inventive principle can also be applied on the back side of the hetero-junction solar cell. In such photovoltaic devices, a back passivation layer is formed on a back surface of the crystalline semiconductor body, a back surface field layer is formed on the back passivation layer and a back electrode is formed on the back surface field layer. The back electrode comprises a back-sided transparent conductive material stack and a metallic contact layer.

The back transparent conductive material stack is a stack of at least two transparent conductive components having different compositions, wherein the back-sided transparent conductive material stack comprises: a back-sided first transparent conductive layer formed on the back surface field layer and consisting of a third base material with a third doping and having a non-stoichiometric composition with a first deviation from stoichiometry, wherein the third base material is chosen from the group including indium oxide, zinc oxide, tin oxide, and cadmium oxide, and a back-sided second transparent conductive layer or structure consisting of the third base material or a fourth base material, said third or fourth base material having the third doping or a fourth doping being different from the third doping and having a non-stoichiometric composition, wherein the composition of the fourth base material is different from the composition of the third base material and wherein the composition of the third base material has a fourth deviation from stoichiometry being different from the third deviation of stoichiometry, respectively. Moreover, the average carrier concentration of the whole back transparent conductive material stack is between 1 x 10²⁰ cm⁻³ and 2 x 10²⁰ cm⁻³; the refractive indices (n) of the back-sided first transparent conductive layer and of the back-sided second transparent conductive layer or structure are in the same range, wherein n > 2 at a wavelength of about 550 nm; and the carrier mobility in the back-sided first transparent conductive layer is higher than the carrier mobility in the back-sided second transparent conductive layer or structure if the layers/structure have a comparable thickness.

The third and/or the fourth doping can be equal or different from the first and/or the second doping of transparent conductive layers on the front side of the photovoltaic device.

For the suggested back-side-structure of the solar cell, especially for the structure and the function of the components of the back-sided transparent conductive material stack, the same applies as explained before with regard to front-sided transparent conductive material stack. Therefore, here is reference made to the description above.

Preferably but not necessarily, the front-sided first transparent conductive layer is formed on the emitter or the front surface field layer, and the front-sided second transparent conductive layer or structure is formed on top of the front-sided first transparent conductive layer. It is furthermore possible to place the back-sided first transparent conductive layer on the back surface field layer or on the back-sided emitter, and to form the back-sided second transparent conductive layer or structure on top of the back-sided first transparent conductive layer.

In another variant of the invention, the front grid metallization is formed on the front-sided second transparent conductive layer or structure before putting the front-sided first transparent conductive layer on the whole area of the solar cell. In this variant, it is necessary to protect the contact electrode during the deposition of the first transparent conductive layer. This protection will result in a free contact area for an electric contact to the fingers of the front grid metallization by a bus-bar electrode.

In the following as well as in the claims, the expression "first transparent conductive layer" without further concretion applies for "front-sided first transparent conductive layer" as well as for "back-sided first transparent conductive layer". Furthermore, the expression "second transparent conductive layer" without further concretion applies for "front-sided second transparent conductive layer" as well as for "back-sided second transparent conductive layer". Moreover, the expression "transparent conductive material stack" without further concretion applies for "front-sided transparent conductive material stack" as well as for "back-sided transparent conductive material stack".

In a favourable embodiment of the invention, at least a part of the second transparent conductive layer or structure is formed on the whole area of the photovoltaic device.

In another variant of the invention, at least a part of the second transparent conductive layer or structure is localized under at least parts of the front grid metallization.

That means, the second transparent conductive layer or structure can be located only below the front metallization grid (selective TCM structure) or on the whole area of the solar cell.

In another advantageous example of the present invention, the transparent conductive material stack further comprises a third transparent conductive layer formed on the front side of the photovoltaic device between the emitter or the front surface field layer and the front-sided transparent conductive material stack and/or formed on the back side of the photovoltaic device between the back surface field layer or the back-sided emitter and the back-sided transparent conductive material stack, wherein the third transparent conductive layer has a work function being higher if put on a p-doped emitter or back-sided emitter or back surface field layer or front surface field layer than the work function of the layers/structures of the transparent conductive material stack or being lower if put on a n-doped emitter or back-sided emitter or back surface field layer or front surface field layer than the work function of the layers/structures of the transparent conductive material stack.

In inverted hetero-junction solar cells, the third transparent conductive layer can be provided between the front surface field layer and the front-sided first transparent conductive layer and/or between the back-sided emitter and the back-sided first transparent conductive layer wherein the third transparent conductive layer has the same features as described above.

It has been turned out that especially suitable material(s) for forming the first transparent conductive layer and/or the second transparent conductive structure and/or the third transparent conductive layer is/are material(s) such as indium oxide, zinc-oxide, tin oxide, and cadmium oxide.

Moreover, it is recommendable to cover the front-sided second transparent conductive structure by an additional antireflection coating to provide a double antireflective feature to improve the current density of the photovoltaic device. As material(s) for forming the additional antireflection coating, material(s) such as MgF₂, SiO₂, ZrO₂, TiO₂, CeF₃, and/or Al₂O₃ have been proven to be beneficial.

The object is further solved by a method of the above mentioned type, wherein the front-sided transparent conductive material stack is provided by forming a stack of at least two transparent conductive components having different compositions, comprising the steps of: forming a front-sided first transparent conductive layer on the emitter, wherein the front-sided first transparent conductive layer is formed using a first base material with a first doping and having an non-stoichiometric composition with a first deviation from stoichiometry, and wherein the first base material is chosen from the group of materials including indium oxide, zinc oxide, tin oxide, and cadmium oxide, and forming a front-sided second transparent conductive layer or structure, wherein the front-sided second transparent conductive structure is formed using the first base material or a second base material, said first or second base material having the first doping or a second doping being different from the first doping and having a non-stoichiometric composition, wherein the composition of the second base material is different from the composition of the first base material and wherein the composition of the first base material has a second deviation from stoichiometry being different from the first deviation from stoichiometry, respectively. In addition, the average carrier concentration of the front-sided transparent conductive material stack is between 1 x 10²⁰ cm⁻³ and 2 x 10²⁰ cm⁻³; the refractive indices (n) of the front-sided first transparent conductive layer and of the front-sided second transparent conductive layer or structure are in the same range, wherein n > 2 at a wavelength of about 550 nm; and the carrier mobility in the front-sided first transparent conductive layer is higher than the carrier mobility in the front-sided second transparent conductive layer or structure if the layers/structure have a comparable thickness.

In so doing, a photovoltaic device with the above mentioned favorable features can be manufactured in a relatively easy way. By a suitable choice of the base materials, of their deviations from stoichiometry, their doping and of the layer thicknesses used for the formation of the transparent conductive layers/structures and by an adapted combination of these layers/structures in the transparent conductive material stack, the formed transparent conductive material can fulfill all requirements for a high efficiency solar cell.

In order to make the inventive idea usable on the back side of a solar cell, the method comprises the following additional steps: forming a back passivation layer on a back surface of the crystalline semiconductor body; forming a back surface field layer or a back-sided emitter on the back passivation layer; and providing a back electrode on the back surface field layer or on the back-sided emitter by forming a back-sided transparent conductive material stack and forming a metallic contact layer. In this method, the back-sided transparent conductive material stack is provided by forming a stack of at least two transparent conductive components having different compositions, comprising the steps of forming a back-sided first transparent conductive layer on the back surface field layer, wherein the back-sided first transparent conductive layer is formed using a third base material with a third doping and having a non-stoichiometric composition with a third deviation from stoichiometry, and wherein the third base material is chosen from the group of materials including indium oxide, zinc oxide, tin oxide, and cadmium oxide, and forming a back-sided second transparent conductive layer or structure on top of the back-sided first transparent conductive layer, wherein the back-sided second transparent conductive structure is formed using the third base material or a fourth base material, said third or fourth base material having the third doping or a fourth doping being different from the third doping and having a non-stoichiometric composition, wherein the composition of the fourth base material is different from the composition of the third base material and wherein the composition of the third base material has a fourth deviation from stoichiometry, being different from the third deviation from stoichiometry, respectively. Furthermore, the average carrier concentration of the back-sided transparent conductive material stack is between 1 x 10²⁰ cm⁻³ and 2 x 10²⁰ cm⁻³; the refractive indices (n) of the back-sided first transparent conductive layer and of the back-sided second transparent conductive layer or structure are in the same range, wherein n > 2 at a wavelength of about 550 nm; and the carrier mobility in the back-sided first transparent conductive layer is higher than the carrier mobility in the back-sided second transparent conductive layer or structure if the layers/structure have a comparable thickness.

Preferably, but not necessarily, the first transparent conductive layer and the second transparent conductive layer or structure are doped differently. This can be realized by the use of different doping materials and/or the use of different doping material concentrations during the deposition of these layers/structures.

In a preferred embodiment of the method of the present invention, the forming of the at least two transparent conductive components comprises the steps of forming the first transparent conductive layer on the emitter, said first transparent conductive layer consisting of a material with a first transparency and a first resistivity and forming the second transparent conductive layer or structure on top of the first transparent conductive layer, said second transparent conductive layer or structure consisting of a material with a second transparency and a second resistivity; wherein the first transparency being higher than the first transparency and the second resistivity being lower than the first resistivity.

The present invention proposes also different manufacturing process flows in order to realize the TCM stack below the front grid metallization and/or on the back side of the photovoltaic device.

In an appropriate version of the method of the present invention, the second transparent conductive layer or structure is deposited as a layer on the whole surface of the first transparent conductive layer or on the whole surface of the emitter and is structured by etching, wherein the front grid metallization acts as a mask during the etch process. This solution allows a self alignment process to form the structured second transparent conductive layer or structure under the front grid metallization. In principle, this kind of preparation can also be applied on the back side of the solar cell, for instance for contacting of a back-sided emitter of an inverted hetero-junction structure. In the latter case, a suitable metallic contact pattern on the back-side of the structure can act as a mask during the etch process.

According to another option, the material of the second transparent conductive layer or structure is deposited as a layer on the whole surface of the first transparent conductive layer or on the whole surface of the emitter and is structured by etching, and the front grid metallization is aligned on the structured second transparent conductive layer or structure. Alternatively, the material of the second transparent conductive layer or structure is deposited through a mask, and the front grid metallization is aligned on the structured second transparent conductive layer or structure.

It is moreover beneficial, but not absolutely necessary if contacts of the front grid metallization are protected by a mask or by a soluble ink provided on the contacts, respectively, during the formation of the additional antireflection coating on the transparent conductive material stack. Alternatively, the additional antireflection coating can be structured through a mask before or after the formation of the contacts of the front grid metallization.

Beneficial embodiments of the present invention, including their structure, function and advantages, are now explained with reference to the figures, wherein in all figures TC1 is a first transparent conductive layer, TC2 is a second transparent conductive layer or structure, and TC3 is a third transparent conductive layer of a TCM stack. In the figures, same or similar reference numerals reference components of the photovoltaic devices with same or similar features. Therefore, in the following, a repeated description of such components was avoided because previous descriptions of components of a photovoltaic device referenced with certain reference signs can be used for the understanding of equally referenced components of the photovoltaic devices in further figures.
- Fig. 1: is a schematic cross sectional view of a hetero-junction solar cell of the present invention with a TCM stack consisting of two layers: TC1 and then TC2 over the full area of the solar cell.
- Fig. 2: is a more detailed schematic cross sectional view of the hetero-junction solar cell of Fig. 1 showing a possible composition of the back electrode of the hetero-junction solar cell of Fig. 1.
- Fig. 3: is a schematic cross sectional view of a hetero-junction solar cell of the present invention with a TCM stack comprising a first transparent conductive layer TC1 formed as a layer on the whole surface and a structured second transparent conductive layer TC2 being localized below the front grid metallization.
- Fig. 4: is a schematic cross sectional view of a hetero-junction solar cell according to an embodiment of the present invention being based on the solar cell of Fig. 1 with a TCM stack consisting of two layers and an additional antireflection coating over the whole surface of the solar cell.
- Fig. 5: is a schematic cross sectional view of a hetero-junction solar cell according to another embodiment of the present invention being based on the solar cell of Fig. 2 with a TCM stack consisting of a first transparent conductive layer formed over the whole surface and a second structured transparent conductive layer, wherein an additional antireflection coating is provided on top of the structure coating the whole surface of the solar cell.
- Fig. 6: is a schematic cross sectional view of a hetero-junction solar cell of the present invention with a TCM stack consisting of three transparent conductive layers/structures: TC3, TC1, and TC2 over the whole area of the solar cell.
- Fig. 7: is a schematic cross sectional view of a hetero-junction solar cell of the present invention with a TCM stack consisting of three transparent conductive layers: TC3, TC1, and then TC2 localized below the front grid metallization.
- Fig. 8: is a schematic cross sectional view of a hetero-junction solar cell according to a variant of the present invention being based on the solar cell of Fig. 6 plus an additional antireflection coating.
- Fig. 9: is a schematic cross sectional view of a hetero-junction solar cell according to another variant of the present invention being based on the solar cell of Fig. 7 plus an additional antireflection coating.
- Fig. 10: is a schematic isometric view of a hetero-junction solar cell according to an embodiment of the present invention with selective additional antireflection coating.
- Fig. 11: is a schematic top view of the solar cell of Fig. 10 with selective additional antireflection coating.
- Fig. 12: is a schematic A-A cross sectional view of the solar cell of Fig. 11 with deposited additional antireflection coating except on top of the electrode.
- Fig. 13: is a schematic B-B cross sectional view of the solar cell of Figs. 11 and 12 without additional antireflection coating deposited on top of the electrode.
- Fig. 14: is a schematic cross sectional view of a hetero-junction solar cell of the present invention with a TCM stack consisting of two transparent conductive layers/structures: TC1, and then TC2 over the whole surface of the solar cell, wherein TC2 having different thicknesses under the front grid metallization and in between the fingers of the solar cell.
- Fig. 15: is a schematic cross sectional view of a hetero-junction solar cell according to an embodiment of the present invention being based on the solar cell of Fig. 14 with a TCM stack consisting of two transparent conductive layers/structures and an additional antireflection coating.
- Fig. 16: is a schematic cross sectional view of a hetero-junction solar cell of the present invention with a TCM stack consisting of three transparent conductive layers/structures: TC3, TC1, and then TC2 localized below the front grid metallization, wherein TC2 having different thicknesses under the front grid metallization and in between the fingers of the solar cell.
- Fig. 17: is a schematic cross sectional view of a hetero-junction solar cell according to an embodiment of the present invention being based on the solar cell of Fig. 16 with a TCM stack consisting of three transparent conductive layers/structures and an additional antireflection coating.
- Fig. 18: compares normalized values of the short circuit current density (J_{SC}), the fill factor (FF) and the efficiency (ETA) of hetero-junction solar cells of the state of the art with the according values of a solar cell according to the present invention.
- Fig. 19: is a schematic cross sectional view of a hetero-junction solar cell according to an embodiment of the present invention having a TCM stack wherein a second transparent conductive layer is provided on the emitter, a front metallization is provided on the second transparent conductive layer and a first transparent conductive layer is provided on top of the second transparent conductive layer.
- Fig. 20: is a schematic cross sectional view of a hetero-junction solar cell according to an embodiment of the present invention being based on the solar cell of Fig. 19 with an additional antireflection coating.
- Fig. 21: is a schematic cross sectional view of a hetero-junction solar cell according to an embodiment of the present invention having a TCM stack wherein a third transparent conductive layer is provided on the emitter, a second transparent conductive layer is provided on the third transparent conductive layer, a front metallization is provided on the second transparent conducive layer and a first transparent conductive layer is provided on top of the second transparent conductive layer.
- Fig. 22: is a schematic cross sectional view of a hetero-junction solar cell according to an embodiment of the present invention being based on the solar cell of Fig. 21 with an additional antireflection coating.

As mentioned above, hetero-junction solar cells manufactured at this time with one front TCM layer, generally indium tin oxide (ITO), suffer from a low current density (J_{SC}) due to the relative large carrier density and small mobility of the free carriers. Standard ITO can be replaced with other highly transparent TCM such as indium oxide (IO), but the latter material suffers from a high contact resistance (i.e. lower FF) with the front metallization grid.

The present invention proposes to use a combination of highly transparent and highly conductive TCM in order to increase the current density and to decrease the contact resistance with the front metallization.

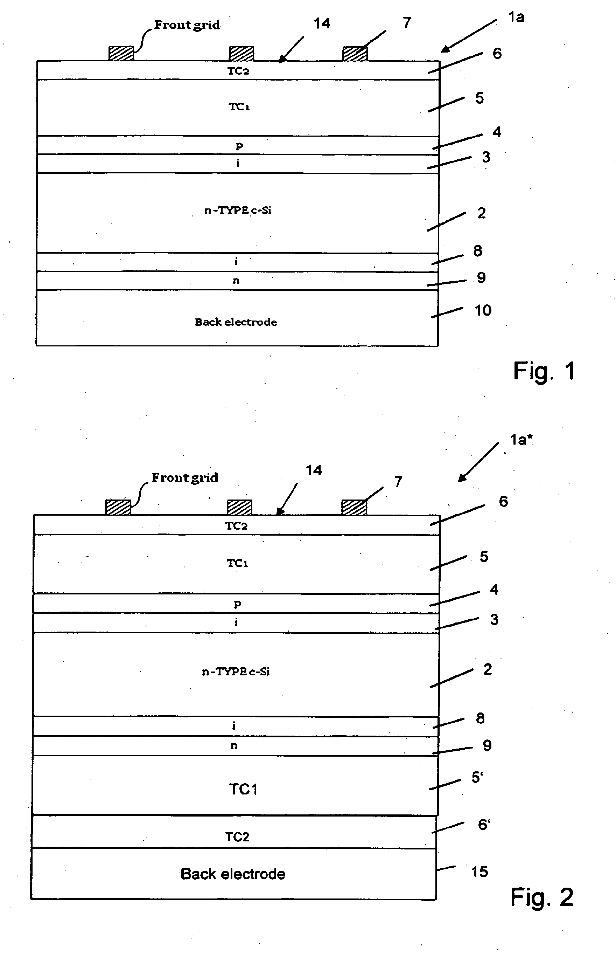

Fig. 1 shows schematically a cross section of a photovoltaic device 1 a according to an embodiment of the present invention. The shown photovoltaic device 1 a is a semi-finished silicon hetero-junction solar cell having a front-side 14 for an incidence of light into the photovoltaic device 1 a. In other non-shown embodiments of the invention, the photovoltaic device 1a can also be based on one or more other semi-conductive materials instead of silicon. Furthermore, the number and the features of the layers of the photovoltaic device 1 a can be in other embodiments of the invention different to the embodiments shown in the figures.

The photovoltaic device 1 a of Fig. 1 comprises a crystalline semiconductor body 2 of a first carrier type being in the embodiment shown an n-type silicon wafer. In other embodiments of the invention, instead of the crystalline semiconductor body 2 also other semiconductor substrates can be used.

The crystalline semiconductor body 2 is processed as it is typical for the manufacturing of hetero-junction silicon solar cells. During this process, the according crystalline semiconductor body 2 is, for example, textured in a potassium hydroxide solution and then cleaned. A hydrofluoric acid dip is performed to remove the native oxide prior to the following surface passivation done by PE-CVD.

Then, passivation layers 3, 8 are formed on the front and on the back side of the semiconductor body 2, the passivation layers 3, 8 being in the embodiment shown intrinsic hydrogenated amorphous silicon layers (a-Si:H). The a-Si:H layers may be deposited via PE-CVD (plasma enhanced chemical vapor deposition). In other embodiments of the invention, the passivation layers 3, 8 can also be of another material(s) than a-Si:H and/or can be formed in different steps.

An emitter 4 is formed on the surface of the passivation layer 3. The emitter 4 is of a second carrier type which is in the example shown contrary to the first carrier type of the semiconductor body 2. In the embodiment shown in Fig. 1, the emitter 4 is of p-type.

A back surface field layer 9 is formed on the passivation layer 8. The back surface field layer 9 is in the example shown of the same carrier type as the first carrier type of the crystalline semiconductor body 2. In the embodiment shown in Fig. 1, the back surface field layer 9 is therefore of n-type.

Furthermore, on the front side of the photovoltaic device 1 a, a front-sided transparent conductive material stack is formed on the emitter 4. The front-sided transparent conductive material stack consists in the embodiment shown of two layers, a front-sided first transparent conductive layer (TC1) 5 and a front-sided second transparent conductive layer (TC2) 6. The front-sided first transparent conductive layer 5 is formed on the emitter 4 and consists of a first base material with a first deviation from stoichiometry and a first dopant material. The first base material is chosen from the group of materials including indium oxide, zinc oxide, tin oxide, and cadmium oxide. The front-sided second transparent conductive layer 6 is in the embodiment shown formed on top of the front-sided first transparent conductive layer 5 and consists of the same base material or a second base material with a second deviation from stoichiometry and a second dopant material.

The average carrier concentration of the whole front-sided transparent conductive material stack is between 1 x 10²⁰ cm⁻³ and 2 x 10²⁰ cm⁻³. The refractive indices (n) of the front-sided first transparent conductive layer 5 and of the front-sided second transparent conductive layer 6 are in the same range, wherein n > 2 at a wavelength of about 550 nm. Furthermore, the carrier mobility in the font-sided first transparent conductive layer 5 is higher than the carrier mobility in the front-sided second transparent conductive layer 6 if the layers 5 and 6 have a comparable thickness.

In the example shown in Fig. 1, the carrier concentration of the second transparent conductive structure 6 is higher than the carrier concentration of the front-sided first transparent conductive layer 5, and the resistivity of the front-sided second transparent conductive structure 6 is lower than the resistivity of the front-sided first transparent conductive layer 5. This is valid in the specific case in which the same base material and the same doping are used for the front-sided first transparent conductive layer 5 and the front-sided second transparent conductive structure 6.

Moreover, a front grid metallization 7 is formed on the front-sided second transparent conductive layer 6. In the embodiment shown, the front grid metallization 7 consists of silver fingers being provided in a spaced apart way on the surface of the solar cell. In the example shown, the silver grid is screen printed and then annealed at low temperature.

Alternatively, the front grid metallization 7 can be formed by an electroplating technique using a structured insulating layer deposited on the front-sided second transparent conductive layer 6. This insulating layer could be the additional antireflective coating 11 described below.

On the back side of the photovoltaic device 1 a of Fig. 1, a back electrode 10 is provided.

Fig. 2 schematically shows a photovoltaic device 1a* being based on the photovoltaic device 1a of Fig. 1 and giving a more detailed example for a possible structure of the back electrode 10 of the photovoltaic device 1 a of Fig. 1. It is therefore made reference to the description above regarding this front-side structure of the photovoltaic device 1 a comprising the front-sided transparent conductive material stack. The back electrode of the photovoltaic device 1a* comprises a back-sided transparent conductive material stack on the back side of the crystalline semiconductor body 2. The back-sided transparent conductive material stack comprises in the embodiment shown a back-sided first transparent conductive layer 5' and a back-sided second transparent conductive layer 6' formed on the back-sided first transparent conductive layer 5'. The layer 5', 6' have similar features as the layer 5, 6 on the front side of the solar cell. Therefore, here is reference made to the above description. The back electrode further comprises a metallic contact layer 15 being formed on the back-sided second transparent conductive layer 6'. In the embodiment shown, the metallic contact layer 15 consists of a silver layer being sputtered on the back-sided transparent conductive layer 6'.

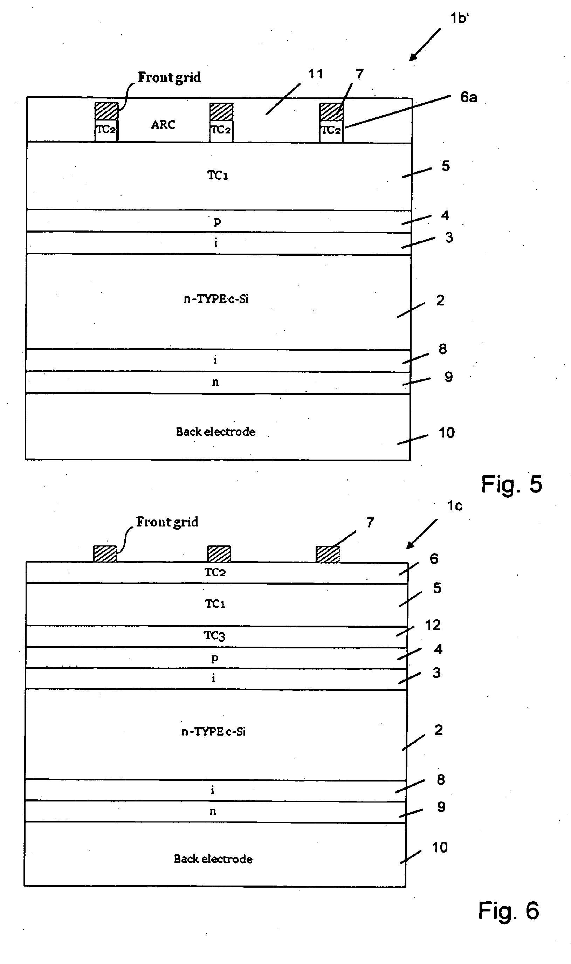

In other non-shown embodiments of the present invention, the back-sided transparent conductive material stack can also have another composition. In particular, the back-sided transparent conductive material stack can comprise one or more additional transparent conductive layers such as at least one layer being comparable with the third transparent conductive layer 12 of Fig. 6 and being formed between the back surface field layer 9 and the back-sided first transparent conductive layer 5'. This non-shown third transparent conductive layer can have a work function being higher if put on a p-doped surface field layer than the work function of the back-sided first transparent conductive layer 5' or being lower if put on a n-doped back surface field layer 9 than the work function of the back-side first transparent conductive layer 5'.

The following tables show (a) in general and (b) exemplarily from which materials combinations the front- and the back-sided transparent conductive material stacks may consist:

| first transparent conductive layer | | | second transparent conductive layer | | |
|---|---|---|---|---|---|
| material | stoichiometry | doping | material | stoichiometry | doping |
| A | XY_1 | a | A | XY_2 | a |
| A | XY_1 | b | A | XY_2 | a |
| A | XY_1 | b | B | XY_3 | c |

(a)

| first transparent conductive layer | | | second transparent conductive layer | | |
|---|---|---|---|---|---|
| material | stoichiometry | doping | material | stoichiometry | doping |
| In₂O₃ | Inₓ₁O_{y1} | 10% tin | In₂O₃ | Inₓ₂O_{y2} | 10% tin |
| In₂O₃ | Inₓ₁O_{y1} | 0% tin | In₂O₃ | Inₓ₂O_{y2} | 10% tin |
| In₂O₃ | Inₓ₁O_{y1} | 0% tin | ZnO | Znₓ₃O_{y3} | 1% Al |

(b)

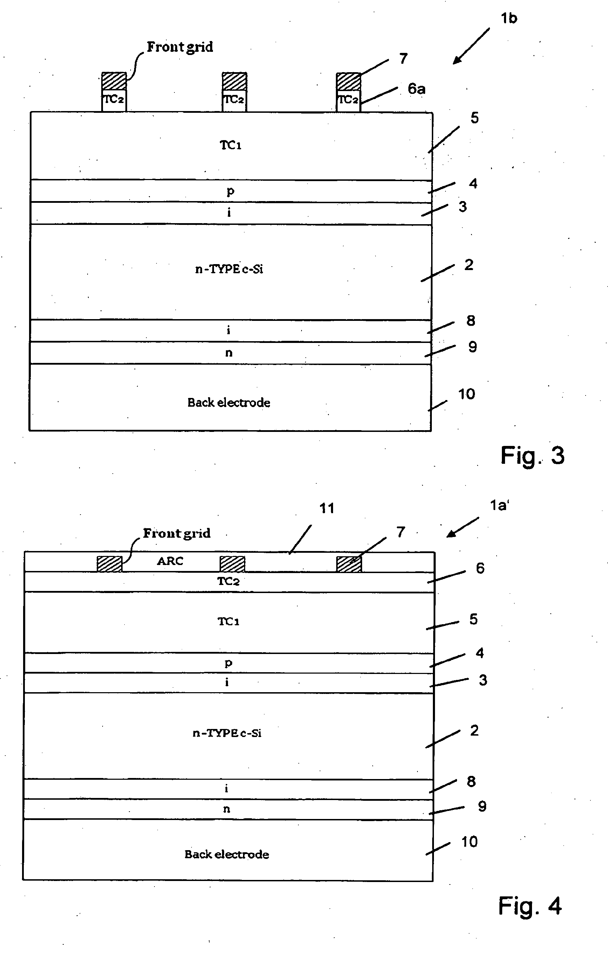

In another embodiment of a solar cell, shown in Fig. 3, the structure of the photovoltaic device 1b is similar to the structure of the solar cell of Fig. 1. Therefore, same reference signs are chosen for same or similar details of the structure. Herewith, reference is made to the description of these details above. In comparison to Fig. 1, the front-sided second transparent conductive structure 6a of Fig. 3 is located only under the front grid metallization 7. This will be achieved by deposition of the front-sided second transparent conductive structure 6a through a mask (not shown), wherein the front grid metallization 7 is aligned on the localized front-sided second transparent conductive structure 6a. This will also be achieved by a deposition of the front-sided second transparent conductive layer 6 on the whole area, and using the front grid metallization 7 as a mask during the etch step of front-sided second transparent conductive layer 6.

Fig. 4 schematically shows a photovoltaic device 1 a' according to an embodiment of the present invention. The photovoltaic device 1 a' is based on the structure of the solar cell shown in Fig. 1. Moreover, an additional antireflection coating 11 is deposited on the front side of the solar cell. The additional antireflection coating 11 covers the front-sided second transparent conductive layer 6 which is in the embodiment shown formed on the whole surface of the front-sided first transparent conductive layer 5. The additional antireflection coating 11 improves the current density of the solar cell.

Fig. 5 schematically shows a cross section of a photovoltaic device 1 b' according to an embodiment of the present invention. The photovoltaic device 1b' is based on the structure of the solar cell shown in Fig. 3. Moreover, an additional antireflection coating 11 is deposited on the front side of the solar cell. The additional antireflection coating 11 covers the front-sided second transparent conductive structure 6a and the front-sided first transparent conductive layer 5.

Fig. 6 schematically shows a cross sectional view of a photovoltaic device 1c, wherein same or similar elements of the structure shown in Fig. 1 are referenced with the same reference numerals. These elements are described above with regard to Fig. 1 and, in more detail, with regard to Fig. 2. In contrast to Fig. 1, the solar cell of Fig. 6 comprises a third transparent conductive layer 12 (TC3) provided between the emitter 4 and the front-sided first transparent conductive layer 5, resulting in a TCM stack consisting of three transparent conductive layers/structures. In case of p-type emitter 4, the third transparent conductive layer 12 has a high work function being higher than the work function of the front-sided first transparent conductive layer 5 and decreases this way the electrical contact resistance between the emitter 4 and the TCM stack. Alternatively, in case of n-type emitter, the third transparent conductive layer (TC3) 12 has a work function being lower than the work function of the front-sided first transparent conductive layer 5.

In summary, the third transparent conductive layer 12 has a work function being higher if put on a p-doped emitter 4 than the work function of the front-sided first transparent conductive layer 5 or being lower if put on a n-doped emitter 4 than the work function of the front-sided first transparent conductive layer 5.

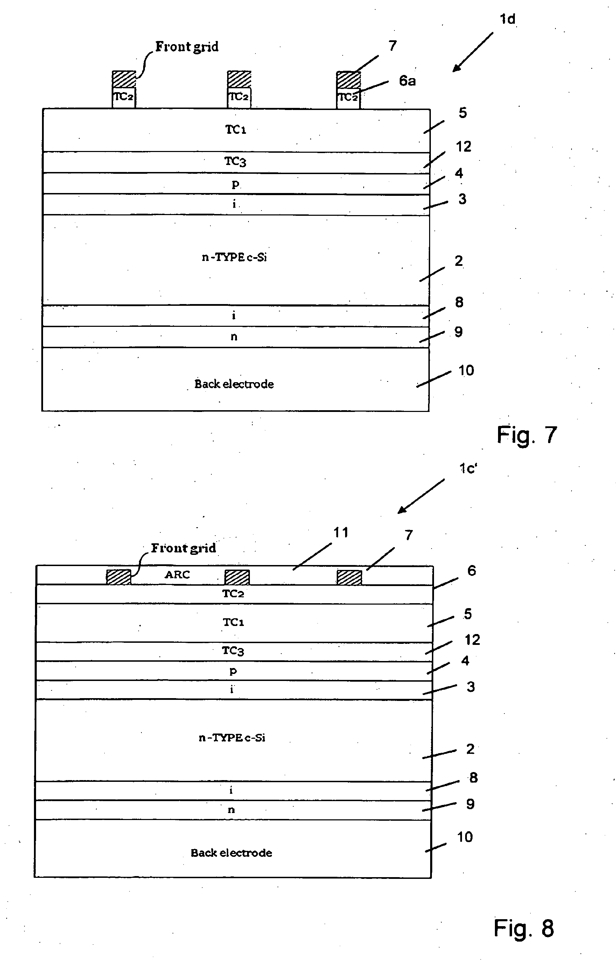

Fig. 7 schematically shows a cross sectional view of a photovoltaic device 1d, wherein same or similar elements of the structure shown in Figs. 1 and 6 are referenced with the same reference numerals. These elements are described above with regard to Figs. 1 and 6. In comparison to Figs. 1 and 6, the front-sided second transparent conductive structure 6a is similarly structured as in the embodiment of Fig. 3. That means, the front-sided second transparent conductive structure 6a is only provided under the fingers of the front grid metallization 7.

Fig. 8 is a schematic cross sectional view of a hetero-junction solar cell 1 c' according to a variant of the present invention being based on the solar cell of Fig. 6 plus an additional antireflection coating 11. In an especially favorable variant of the invention, the front-sided first transparent conductive layer 5 of Fig. 8 consists of indium oxide having a high transparency, the front-sided second transparent conductive layer 6 consists of indium tin oxide having a high carrier concentration, the third transparent conductive layer 12 consists of indium tin oxide having a low carrier concentration and the additional antireflection coating 11 is of MgF₂.

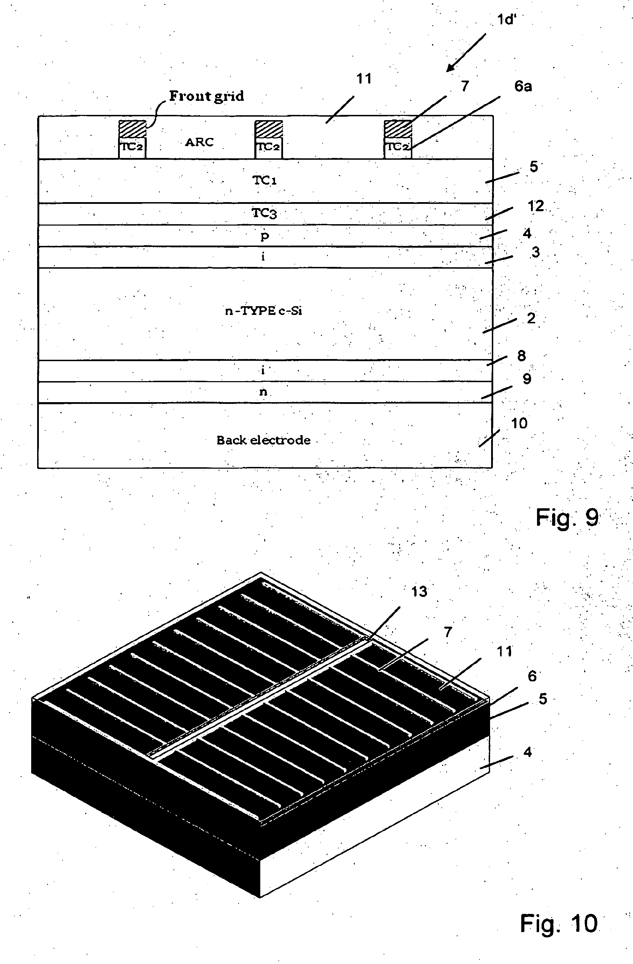

Fig. 9 is a schematic cross sectional view of a hetero-junction solar cell 1d' according to another variant of the present invention and is based on the solar cell of Fig. 7 plus an additional antireflection coating 11.

Fig. 10 shows schematically a front part of a solar cell with an emitter 4, a front-sided first transparent conductive layer 5, a front-sided second transparent conductive layer 6, a front grid metallization 7 and an additional antireflection coating 11 in a perspective view. As shown in Fig. 10, the additional antireflection coating 11 was deposited in a selective way, resulting in a free contact area for an electric contact to the fingers of the front grid metallization 7 by a bus-bar electrode 13.

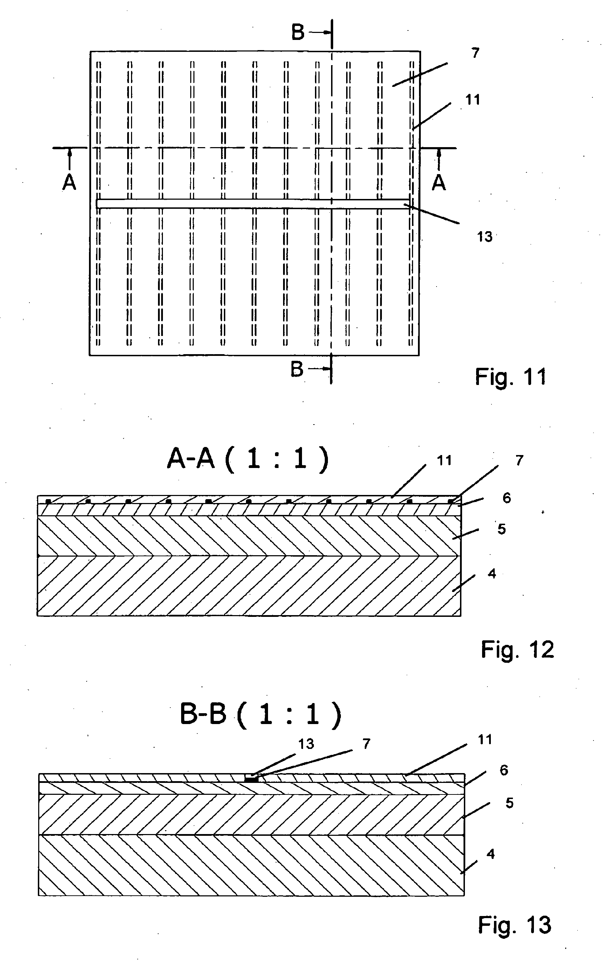

Fig. 11 schematically shows a top view of a solar cell structure being similar to the solar cell of Fig. 10.

Fig. 12 is a schematic A-A cross sectional view of the solar cell of Fig. 11 with deposited additional antireflection coating 11 except on top of the electrode 13.

Fig. 13 is a schematic B-B cross sectional view of the solar cell of Figs. 10 and 11 without additional antireflection coating 11 deposited on top of the electrode 13.

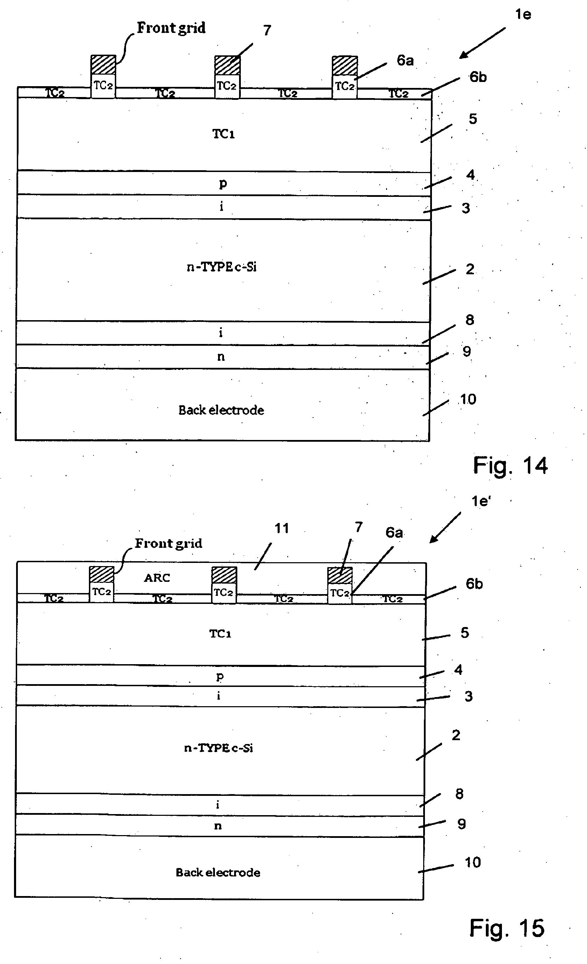

Fig. 14 is a schematic cross sectional view of a hetero-junction photovoltaic device 1 e with a TCM stack consisting of two transparent conductive layers/structures. A first transparent conductive layer 5 (TC1) is provided over the whole surface of the emitter 4. Then, a front-sided second transparent conductive structure 6a, 6b is deposited over the whole surface of the front-sided first transparent conductive layer 5. Below the front grid metallization 7, the front-sided second transparent conductive structure 6a has a thicker thickness than in the regions 6b between the fingers of the front grid metallization 7.

Fig. 15 is a schematic cross sectional view of a hetero-junction photovoltaic device 1e' according to an embodiment of the present invention being based on the solar cell of Fig. 14 with a TCM stack consisting of two transparent conductive layers/structures 5; 6a, 6b and an additional antireflection coating 11. A front-sided first transparent conductive layer 5 is formed over the whole surface of the emitter 4. Then, a front-sided second transparent conductive layer/structure 6a, 6b is formed on the whole surface of the front-side first transparent conductive layer 5. Below the front grid metallization 7, the front-sided second transparent conductive layer/structure 6a has a thicker thickness than in the regions 6b between the fingers of the front grid metallization 7.

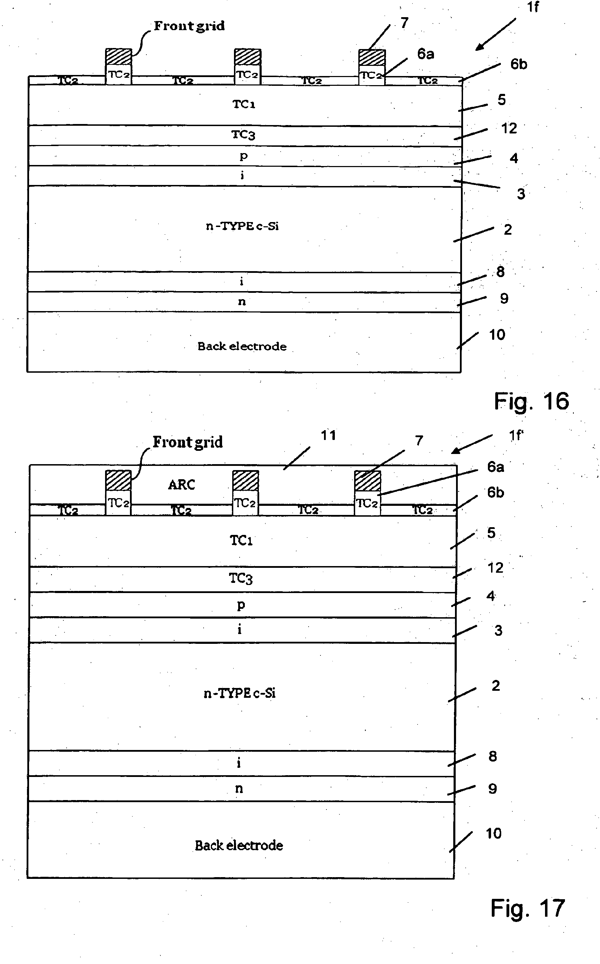

Fig. 16 is a schematic cross sectional view of a hetero-junction photovoltaic device 1f with a TCM stack consisting of three transparent conductive layers/structures 12; 5; 6a, 6b. As in the embodiment of Fig. 14, the TCM stack of the photovoltaic device 1f comprises a third transparent conductive layer 12 deposited on the whole surface of an emitter 4, a front-sided first transparent conductive layer 5 deposited on the whole surface of the third transparent conductive layer 12 and thereon a front-sided second transparent conductive structure 6a, 6b having different thicknesses under the front grid metallization 7 and in between the fingers of the solar cell.

Fig. 17 is a schematic cross sectional view of a hetero-junction photovoltaic device 1f' according to an embodiment of the present invention being based on the solar cell of Fig. 15 with a TCM stack consisting of three different transparent conductive layers/structures and an additional antireflection coating 11.

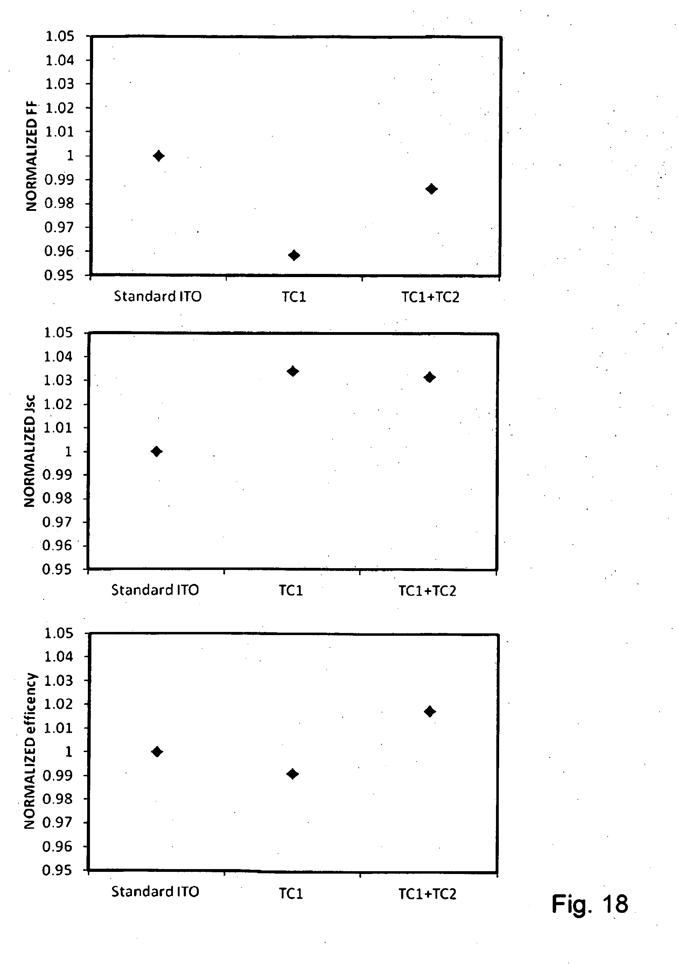

Fig. 18 compares the normalized J_{SC} (short circuit current density), FF (fill factor) and ETA (efficiency) of a hetero-junction cell produced with a standard TCM made with single ITO film ("Standard ITO"), of another silicon hetero-junction solar cell produced with front TCM made with single hydrogen-doped indium oxide film ("TC1") and of a hetero-junction solar cell produced in accordance with an embodiment of the method of the present invention employing a TCM stack consisting of a front-sided first transparent conductive layer (TC1) based on hydrogen-doped indium oxide and a front-sided second transparent conductive layer (TC2) based on ITO ("TC1+TC2"). The short circuit current density is strongly improved by the highly transparent TC1 and the loss in FF is limited by the appropriate electrical contact of TC2 with the front grid metallization. The resulting solar cell of the present invention shows an improved efficiency of about 2% relative.

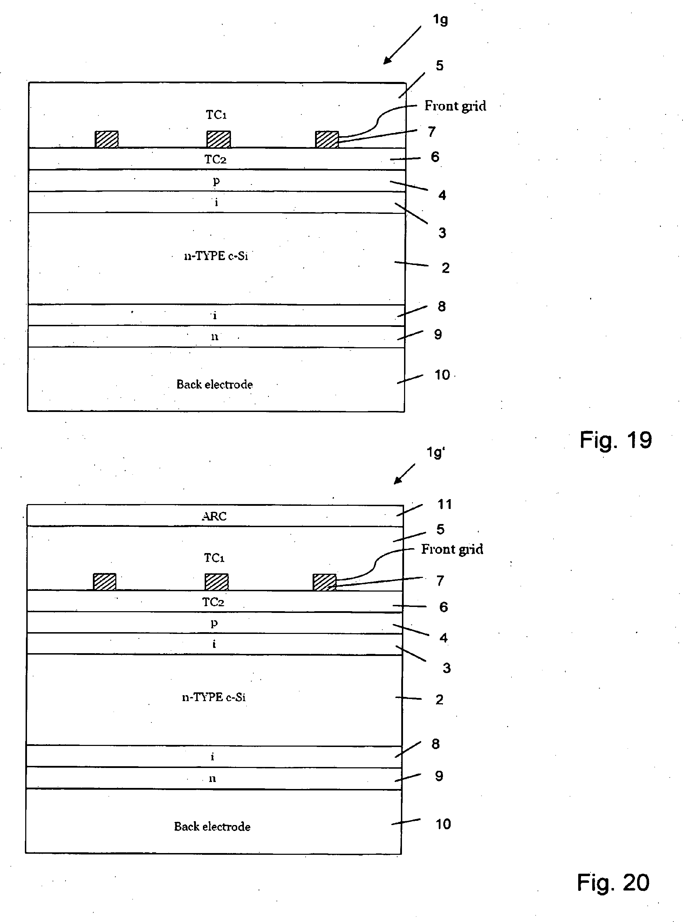

Fig. 19 is a schematic cross sectional view of a hetero-junction solar cell 1 g according to an embodiment of the present invention. The hetero-junction solar cell 1 g comprises a TCM stack of two transparent conductive layers/structures, wherein a second transparent conductive layer 6 of this TCM stack is provided on the whole surface of an emitter 4, fingers of a front metallization 7 are provided on the front-sided second transparent conducive layer 6 and a front-sided first transparent conductive layer 5 of the TCM stack is provided on top of the front-sided second transparent conductive layer 6 in a selected way, resulting in a free contact area for an electric contact to the fingers of the front grid metallization 7 by a bus-bar electrode 13.

Fig. 20 is a schematic cross sectional view of a hetero-junction solar cell 1g' according to an embodiment of the present invention being based on the solar cell 1 g of Fig. 19 with a TCM stack of two transparent conductive layers/structures 6, 5 and an additional antireflection coating 11.

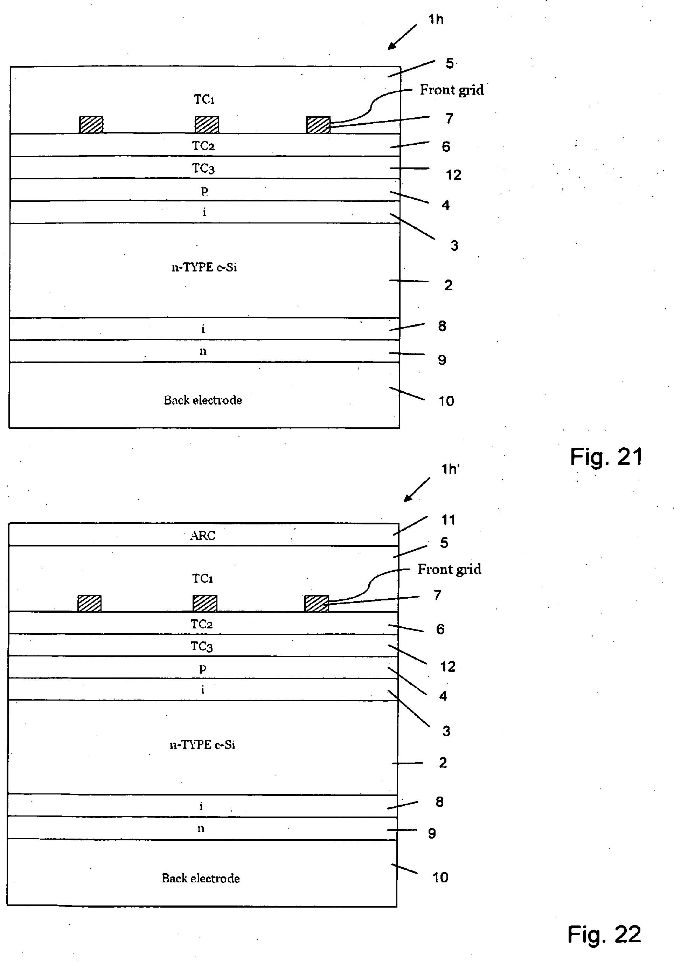

Fig. 21 is a schematic cross sectional view of a hetero-junction solar cell 1 h according to an embodiment of the present invention with a TCM stack consisting of three transparent conductive layers/structures, wherein a third transparent conductive layer 12 is provided on the whole surface of an emitter 4, a front-sided second transparent conductive layer 6 is provided on the whole surface of the third transparent conductive layer 12, fingers of a front metallization 7 are provided on the front-sided second transparent conductive layer 6 and a front-sided first transparent conductive layer 5 is deposited on top of the front-sided second transparent conductive layer 6 in a selective way, resulting in a free contact area for an electric contact to the fingers of the front grid metallization 7 by a bus-bar electrode 13.

Fig. 22 is a schematic cross sectional view of a hetero-junction solar cell 1 h' according to an embodiment of the present invention being based on the solar cell 1 h of Fig. 21 with a TCM stack consisting of three transparent conductive layers/structures and an additional antireflection coating 11.

Although the embodiments of the invention shown in Figs. 1 to 22 comprise the characteristic TCM stack on the front side of the corresponding photovoltaic devices 1a, 1b, 1 c, 1 d, 1 e, 1f, 1g, 1 h, it should be understood that the inventive TCM stack consisting of several TCM layers/structures with different compositions or deviations from stoichiometry and, preferably, different doping can also be applied on the back side of a photovoltaic device. In such cases, the above described inventive TCM stack is provided between the back surface field layer 9 and the metallic contact layer 15 replacing the sputtered thin ITO layer of the prior art. For the details of this TCM stack, reference is made to the above description of the front-side TCM stack which can be applied in a mirror image way on a back-side of the photovoltaic devices 1 a, 1 b, 1 c, 1 d, 1 e, 1 f, 1g, 1 h.

In all embodiments of the invention, the first transparent conductive layer 5 has a low carrier concentration leading to a favorite entry of light into the photovoltaic device 1a, 1b, 1 c, 1d, 1e, 1 f, 1 g, 1 h. Furthermore, with this first transparent conductive layer 5, more photogenerated current is produced out of the device. However, the first transparent conductive layer 5 is not suitable to have a low electrical contact resistance with the front grid metallization 7. Therefore, according to the present invention, the additional second transparent conductive layer or structure 6, 6a, 6b is used between the first transparent conductive layer 5 and the front grid metallization 7. The second transparent conductive layer or structure 6, 6a, 6b has an adequate composition to provide a low electrical contact resistance with the front grid metallization 7.

For example, in the following two manufacturing processes are proposed to form a TCM stack in accordance with an embodiment of the method of the present invention wherein the second transparent conductive structure 6a is localized below the front grid metallization 7 such as it is shown in Fig. 3.

### 1^{st} process flow:

The advantage of the 1^{st} hetero-junction process flow is based on the self-alignment of the front grid metallization 7 with the second transparent conductive layer or structure 6 or 6a.
a) deposition of a TCM stack consisting of two transparent conductive layers 5, 6 like in Fig. 1:
   i. deposition of the first transparent conductive layer 5 (highly transparent TC1 layer) on top of the emitter 4 (being in the examples shown a p-doped layer);
   ii. deposition of the second transparent conductive structure 6 (highly conductive TC2 layer) on top of TC1;
b) formation of the fingers of the front grid metallization 7 on the second transparent conductive layer 6; and
c) wet or dry single side etching of the front of the solar cell in order to remove the material of the second transparent conductive structure 6 (TC2 layer) between the fingers of the front grid metallization 7, wherein the front grid metallization 7 plays the role of the mask in this step.

For the wet process, any solution that can etch the material of the second transparent conductive structure 6 but not the material (such as a silver paste) of the front grid metallization 7 can be used. For example, a diluted hydrofluoric acid (HF, 1 % to 50 % diluted) or hydrochloric acid (HCl, 1 % to 50 % diluted) solution can be used. In order to have a good control of the etching rate of the material of the second transparent conductive structure 6, the etching step is preferably (but not necessarily) performed after the curing of the material used for forming the front grid metallization 7.

The etching technique is also possible due to two main characteristics:
a) If, for example, HF solution is used for etching and if the second transparent conductive structure 6 (TC2) consists of ITO, it has a higher etching rate than a first transparent conductive layer 5 (TC1) consisting of IO; in that case, a small over-etch of ITO will not affect the final thickness of the IO layer.
b) Moreover, the thickness/width ratio of the ITO (TC2) layer under the front grid metallization 7 fingers is very small (nm/µm). Therefore, a small IO (first transparent conductive layer 5, TC1) over-etch to assure the complete etching of the ITO (second transparent conductive structure 6, TC2) without damaging the remaining ITO (second transparent conductive structure 6, TC2) layer width under the front grid metallization 7 is possible.

The wet process is preferably done on the front side of the solar cell only.

For a dry process, classic Ar- or Ar/O₂-plasmas can be used to remove the ITO (TC2). The front grid metallization 7 will also act as a mask to prevent the etching of ITO (TC2) under the fingers of the front grid metallization 7.

### 2^{nd} alternative process flow:

a) deposition of a first transparent conductive layer 5 (highly transparent TC1 layer) on top of the emitter 4 (being in the examples shown a p-doped layer);
b) deposition of a second transparent conductive structure 6a (highly conductive TC2 layer on top of TC1) with a mechanical mask; and
c) formation of a front grid metallization 7 with an alignment on top of TC2.

The second process flow proposes a standard mechanical masking technique for the second transparent and highly conductive structure 6a making an alignment necessary between this last TCM layer and the front grid metallization 7.

For any of these process flows: an additional layer can be deposited on the top of the cell acting as an additional antireflective coating 11 (antireflection coating) with double layer antireflective properties (DL antireflection coating). To fulfill the DL antireflection coating properties, the refractive index of the additional antireflection coating 11 has to match the refractive index of the layer underneath. The additional antireflection coating 11 is generally a non-conductive material. Therefore, the additional antireflection coating 11 should not cover the part of the front grid metallization 7 which will be used for the interconnection of the cells in a module or for its own measurement.

For hetero-junction cells, the bus-bar electrode 13 has to be either masked or covered with a soluble ink before the deposition of the additional antireflection coating 11. In the case of soluble ink a simple lift-off technique has to be applied after the antireflection coating 11 deposition to remove the non-conductive material from the metal contacts (Figs. 10, 11, 12, 13).

It should be understood that the above explained method variants of the present invention can be replaced by other variants with amended method steps, materials and devices. In particular, in the above examples, instead of the n-type doped semiconductor body 2, a p-type doped semiconductor body can be used. In that case, the type of doping of the other layers/structures of the respective photovoltaic devices is contrary to the description above. This kind of photovoltaic cells is included in the present invention.

## Claims

1. Photovoltaic device (1a, 1b, 1c, 1d, 1e, 1f, 1g, 1 h, 1g) with a hetero-junction, said photovoltaic device having a front side (14) for an incidence of light and comprising
- a crystalline semiconductor body (2),
- a front passivation layer (3) formed on a front surface of the crystalline semiconductor body (2),
- an emitter (4) or a front surface field layer formed on the front passivation layer (3),
- a front-sided transparent conductive material stack, and
- a front grid metallization (7),
wherein the front-sided transparent conductive material stack is a stack of at least two transparent conductive components having different compositions, wherein the front-sided transparent conductive material stack comprises
- a front-sided first transparent conductive layer (5) consisting of a first base material with a first doping and having a non-stoichiometric composition with a first deviation from stoichiometry, wherein the first base material is chosen from the group of materials including indium oxide, zinc oxide, tin oxide, and cadmium oxide, and
- a front-sided second transparent conductive layer or structure (6, 6a, 6b) consisting of the first base material or a second base material, said first or second base material having the first doping or a second doping being different from the first doping and having a non-stoichiometric composition, wherein the composition of the second base material is different from the composition of the first base material **characterized in that** the composition of the first base material of said front-sided second transparent conductive layer or structure (6, 6a, 6b) has a second deviation from stoichiometry being different from the first deviation from stoichiometry, respectively,
and wherein
the average carrier concentration of the whole front-sided transparent conductive material stack is between 1 x 10²⁰ cm⁻³ and 2 x 10²⁰ cm⁻³;
the refractive indices (n) of the front-sided first transparent conductive layer (5) and of the front-sided second transparent conductive layer or structure (6, 6a, 6b) are in the same range, wherein n > 2 at a wavelength of about 550 nm; and
the carrier mobility in the font-sided first transparent conductive layer (5) is higher than the carrier mobility in the front-sided second transparent conductive layer or structure (6, 6a, 6b) if the layers/structure (5; 6, 6a, 6b) have a comparable thickness.

2. Photovoltaic device of claim 1, **characterized in that** a back passivation layer (8) is formed on a back surface of the crystalline semiconductor body (2), a back surface field layer (9) or a back-sided emitter is formed on the back passivation layer (8), a back electrode (10) is formed on the back surface field layer (9) or on the back-sided emitter, wherein the back electrode (10) comprises a back-sided transparent conductive material stack and a metallic contact layer (15), wherein the back-sided transparent conductive material stack is a stack of at least two transparent conductive components having different compositions, and wherein the back-sided transparent conductive material stack comprises
- a back-sided first transparent conductive layer (5') consisting of a third base material with a third doping and having a non-stoichiometric composition with a first deviation from stoichiometry, wherein the third base material is chosen from the group including indium oxide, zinc oxide, tin oxide, and cadmium oxide, and
- a back-sided second transparent conductive layer or structure (6') consisting of the third base material or a fourth base material, said third or fourth base material having the third doping or a fourth doping being different from the third doping and having a non-stoichiometric composition, wherein the composition of the fourth base material is different from the composition of the third base material and wherein the composition of the third base material has a fourth deviation from stoichiometry being different from the third deviation from stoichiometry, respectively,
wherein
the average carrier concentration of the whole back-sided transparent conductive material stack is between 1 x 10²⁰ cm⁻³ and 2 x 10²⁰ cm⁻³;
the refractive indices (n) of the back-sided first transparent conductive layer (5') and of the back-sided second transparent conductive layer or structure (6') are in the same range, wherein n > 2 at a wavelength of about 550 nm; and
the carrier mobility in the back-sided first transparent conductive layer (5') is higher than the carrier mobility in the back-sided second transparent conductive layer or structure (6') if the layers/structure (5'; 6') have a comparable thickness.

3. Photovoltaic device of at least one of the previous claims, **characterized in that** the front-sided first transparent conductive layer (5) is formed on the emitter (4) or on the front surface field layer, and/or the back-sided first transparent conductive layer (5') is formed on the back surface field layer (9) or on the back-sided emitter.

4. Photovoltaic device of at least one of the previous claims, **characterized in that** at least a part of the second transparent conductive layer or structure (6, 6b; 6') is formed on the whole surface of the photovoltaic device (1a, 1b, 1c, 1 d, 1e, 1 f, 1g, 1 h)

5. Photovoltaic device of at least one of the claims 1 to 3, **characterized in that** at least a part of the second transparent conductive layer or structure (6a) is localized under at least parts of the front grid metallization (7).

6. Photovoltaic device of at least one of the previous claims, **characterized in that** the transparent conductive material stack further comprises a third transparent conductive layer (12) formed on the front side of the photovoltaic device (1a, 1b, 1c, 1 d, 1e, 1f, 1g, 1 h, 1 g) between the emitter (4) or the front surface field layer and the front-sided transparent conductive material stack (5, 6, 6a, 6b) and/or formed on a back side of the photovoltaic device (1a, 1b, 1c, 1d, 1e, 1f, 1g, 1h) between the back surface field layer (9) or the back-sided emitter and the back-sided transparent conductive material stack (5', 6'), wherein the third transparent conductive layer (12) has a work function being higher if put on a p-doped emitter (4) or back-sided emitter or back surface field layer (9) or front surface field layer than the work function of the layers/structures of the transparent conductive material stack (5, 6, 6a, 6b; 5', 6') or being lower if put on a n-doped emitter (4) or back-sided emitter or back surface field layer (9) or front surface field layer than the work function of the layers/structures of the transparent conductive material stack (5, 6, 6a, 6b; 5', 6').

7. Photovoltaic device of at least one of the previous claims, **characterized in that** the second transparent conductive layer or structure (6, 6a, 6b; 6') and/or the third transparent conductive layer (12) consist(s) of at least one material chosen from the group of materials including indium oxide, zinc oxide, tin oxide, and cadmium oxide.

8. Photovoltaic device of at least one of the previous claims, **characterized in that** the front-sided second transparent conductive layer or structure (6, 6a, 6b) is covered by an additional antireflection coating (11).

9. Photovoltaic device of claim 8, **characterized in that** the additional antireflection coating (11) consists of at least one material chosen from the group of materials including MgF₂, SiO₂, ZrO₂, TiO₂, CeF₃, and Al₂O₃.

10. Method of manufacturing a photovoltaic device (1a, 1b, 1 c, 1 d, 1 e, 1 f, 1g, 1h, 1g) with a hetero-junction, said photovoltaic device being prepared with a front side (14) for an incidence of light, wherein the method comprising the steps of
- providing a crystalline semiconductor body (2),
- forming a front passivation layer (3) on the crystalline semiconductor body (2),
- forming an emitter (4) or a front surface field layer on the front passivation layer (3),
- providing a front-sided transparent conductive material stack, and
- forming a front grid metallization (7),
wherein
the front-sided transparent conductive material stack is provided by forming a stack of at least two transparent conductive components having different compositions, comprising the steps of
- forming a front-sided first transparent conductive layer (5) on the emitter (4), wherein the front-sided first transparent conductive layer (5) is formed using a first base material with a first doping and having a non-stoichiometric composition with a first deviation from stoichiometry, and wherein the first base material is chosen from the group of materials including indium oxide, zinc oxide, tin oxide, and cadmium oxide, and
- forming a front-sided second transparent conductive layer or structure (6, 6a, 6b), wherein the front-sided second transparent conductive structure (6, 6a, 6b) is formed using the first base material or a second base material, said first or second base material having the first doping or a second doping being different from the first doping and having a non-stoichiometric composition, wherein the composition of the second base material is different from the composition of the first base material; **characterized in that** the composition of the first base material of said front-sided second transparent conductive layer or structure (6, 6a, 6b) has a second deviation from stoichiometry being different from the first deviation from stoichiometry, respectively,
wherein
the average carrier concentration of the whole front-sided transparent conductive material stack is between 1 x 10²⁰ cm⁻³ and 2 x 10²⁰ cm⁻³;
the refractive indices (n) of the front-sided first transparent conductive layer (5) and of the front-sided second transparent conductive layer or structure (6, 6a, 6b) are in the same range, wherein n > 2 at a wavelength of about 550 nm; and
the carrier mobility in the front-sided first transparent conductive layer (5) is higher than the carrier mobility in the front-sided second transparent conductive layer or structure (6, 6a, 6b) if the layers/structure (5; 6, 6a, 6b) have a comparable thickness.

11. Method of claim 10, **characterized in that** the method further comprises the steps of
- forming a back passivation layer (8) on a back surface of the crystalline semiconductor body (2),
- forming a back surface field layer (9) or a back-sided emitter on the back passivation layer (8),
- forming a metallic contact layer (10) on the surface field layer (9) or on the back-sided emitter, and
- providing a back electrode (10) on the back surface field layer (9) by forming a back-sided transparent conductive material stack and forming a metallic contact layer (15), wherein the back-sided transparent conductive material stack is provided by forming a stack of at least two transparent conductive components having different compositions, comprising the steps of
- forming a back-sided first transparent conductive layer (5'), wherein the back-sided first transparent conductive layer (5') is formed using a third base material with a third doping and having a non-stoichiometric composition with a third deviation from stoichiometry, and wherein the third base material is chosen from the group of materials including indium oxide, zinc oxide, tin oxide, and cadmium oxide, and
- forming a back-sided second transparent conductive layer or structure (6'), wherein the back-sided second transparent conductive structure (6') is formed using the third base material or a fourth base material, said third or fourth base material having the third doping or a fourth doping being different from the third doping and having a non-stoichiometric composition, wherein the composition of the fourth base material is different from the composition of the third base material and wherein the composition of the third base material has a fourth deviation from stoichiometry being different from the third deviation from stoichiometry, respectively,
wherein
the average carrier concentration of the whole back-sided transparent conductive material stack is between 1 x 10²⁰ cm⁻³ and 2 x 10²⁰ cm⁻³;
the refractive indices (n) of the back-sided first transparent conductive layer (5') and of the back-sided second transparent conductive layer or structure (6') are in the same range, wherein n > 2 at a wavelength of about 550 nm; and
the carrier mobility in the back-sided first transparent conductive layer (5') is higher than the carrier mobility in the back-sided second transparent conductive layer or structure (6') if the layers/structure (5'; 6') have a comparable thickness.

12. Method of claim 10 or 11, **characterized in that** the second transparent conductive structure (6a, 6b) is formed as a layer on the whole surface of the first transparent conductive layer (5) or on the whole surface of the emitter (4) or on the whole front surface field layer and is structured by etching, wherein the front grid metallization (7) acts as a mask during the etch process.

13. Method of at least one of the claims 10 or 12, **characterized in that** the material of the second transparent conductive structure (6a, 6b) is deposited as a layer on the whole surface of the first transparent conductive layer (5) or on the whole surface of the emitter (4) or on the whole front surface field layer and is structured by etching, and the front grid metallization (7) is aligned on the structured second transparent conductive layer or structure (6a, 6b).

14. Method of at least one of the claims 10 to 13, **characterized in that** the second transparent conductive layer or structure (6a) is deposited through a mask on the first transparent conductive layer (5) or on the emitter (4) or on the front surface field layer, and the front grid metallization (7) is aligned on the localized second transparent conductive structure (6a).

15. Method of one of the claims 10 to 14, **characterized in that** a third transparent conductive layer (12) is formed between the emitter (4) or the front surface field layer and the transparent conductive material stack (5, 6, 6a, 6b) on the front side of the photovoltaic device (1a, 1b, 1c, 1d, 1e, 1f, 1g, 1h) and/or between the back surface field layer (9) or the back-sided emitter and the transparent conductive material stack (5', 6') on the back side of the photovoltaic device (1a, 1b, 1c, 1 d, 1e, 1 f, 1g, 1 h), wherein the third transparent conductive layer (12) has a work function being higher if put on a p-doped emitter (4) or back-sided emitter or back surface field layer (9) or front surface field layer than the work function of the layers/structures of the transparent conductive material stack (5, 6, 6a, 6b; 5', 6') or being lower if put on a n-doped emitter (4) or back-sided emitter or back surface field layer (9) or front surface field layer than the work function of the layers/structures of the transparent conductive material stack (5, 6, 6a, 6b; 5', 6').

16. Method of one of the claims 10 to 15, **characterized in that** the steps of the method are provided in the following order
- forming the emitter (4) or on the front surface field layer,
- forming the front-sided first transparent conductive layer or structure (5) on the emitter (4) or the front surface field layer,
- forming the front-sided second transparent conductive layer (6, 6a, 6b) on the front-sided first transparent conductive layer or structure (5), and
- forming the front grid metallization (7) on top of the front-sided second transparent conductive layer or structure (6, 6a, 6b).

17. Method of one of the claims 10 to 15, **characterized in that** the steps of the method are provided in the following order
- forming the emitter (4) or the front surface field layer,
- forming the front-sided second transparent conductive layer or structure (6, 6a, 6b) on the emitter (4) or on the front surface field layer,
- forming the front grid metallization (7) on top of the front-sided second transparent conductive layer or structure (6, 6a, 6b), and
- forming the front-sided first transparent conductive layer (5) on the front grid metallization (7).

18. Method of one of the claims 10 to 17, **characterized in that** the front-sided transparent conductive material stack is covered by an additional antireflection coating (11), and contacts of the front grid metallization (7) are protected by a mask or by a soluble ink provided on the contacts, respectively, during the formation of the additional antireflection coating (11).

## Patentansprüche

1. Photovoltaikvorrichtung (1a, 1b, 1c, 1d, 1e, 1f, 1g, 1h, 1g) mit einem Heteroübergang, wobei die Photovoltaikvorrichtung eine Vorderseite (14) für einen Lichteinfall und
- einen kristallinen Halbleiterkörper (2),
- eine Vorderseitenpassivierungsschicht (3), die auf einer vorderseitigen Oberfläche des kristallinen Halbleiterkörpers (2) ausgebildet ist,
- einen Emitter (4) oder eine Vorderseitenoberflächenfeldschicht, die auf der Vorderseitenpassivierungsschicht (3) ausgebildet ist,
- einen vorderseitigen transparenten leitfähigen Materialstapel, und
- eine vorderseitige Gittermetallisierung (7)
aufweist, wobei
der vorderseitige transparente leitfähige Materialstapel ein Stapel aus wenigstens zwei transparenten leitfähigen Bauelementen mit verschiedenen Zusammensetzungen ist, wobei der vorderseitige transparente leitfähige Materialstapel
- eine vorderseitige erste transparente leitfähige Schicht (5), die aus einem ersten Basismaterial mit einer ersten Dotierung besteht und eine nicht-stöchiometrische Zusammensetzung mit einer ersten Stöchiometrieabweichung hat, wobei das erste Basismaterial aus der Materialgruppe ausgewählt ist, welche Indiumoxid, Zinkoxid, Zinnoxid und Cadmiumoxid umfasst, und
- eine vorderseitige zweite transparente leitfähige Schicht oder Struktur (6, 6a, 6b), die aus einem ersten Basismaterial oder einem zweiten Basismaterial besteht, wobei das erste oder zweite Basismaterial eine erste Dotierung oder eine zweite Dotierung, welche sich von der ersten Dotierung unterscheidet, und eine nicht-stöchiometrische Zusammensetzung hat, wobei sich die Zusammensetzung des zweiten Basismaterials von der Zusammensetzung des ersten Basismaterials unterscheidet, aufweist;
**dadurch gekennzeichnet**,
dass die Zusammensetzung des ersten Basismaterials der vorderseitigen zweiten transparenten leitfähigen Schicht oder Struktur (6, 6a, 6b) eine zweite Stöchiometrieabweichung hat, die sich von der ersten Stöchiometrieabweichung jeweils unterscheidet,
und wobei
die durchschnittliche Ladungsträgerkonzentration des gesamten vorderseitigen transparenten leitfähigen Materialstapels zwischen 1 x 10²⁰ cm⁻³ und 2 x 10²⁰ cm⁻³ liegt;
die Brechungsindizes (n) der vorderseitigen ersten transparenten leitfähigen Schicht (5) und der vorderseitigen zweiten transparenten leitfähigen Schicht oder Struktur (6, 6a, 6b) in der gleichen Größenordnung liegen, wobei n > 2 bei einer Wellenlänge von etwa 550 nm ist; und
die Ladungsträgerbeweglichkeit in der vorderseitigen ersten transparenten leitfähigen Schicht (5) höher als die Ladungsträgerbeweglichkeit in der vorderseitigen zweiten transparenten leitfähigen Schicht oder Struktur (6, 6a, 6b) ist, wenn die Schichten/Struktur (5; 6, 6a, 6b) eine vergleichbare Dicke haben.

2. Photovoltaikvorrichtung nach Anspruch 1, **dadurch gekennzeichnet, dass** eine Rückseitenpassivierungsschicht (8) auf einer Rückseitenoberfläche des kristallinen Halbleiterkörpers (2) ausgebildet ist, eine Rückseitenoberflächenfeldschicht (9) oder ein rückseitiger Emitter (4) auf der Rückseitenpassivierungsschicht (8) ausgebildet ist, eine Rückseitenelektrode (10) auf der Rückseitenoberflächenfeldschicht (9) oder auf dem rückseitigen Emitter ausgebildet ist, wobei die Rückseitenelektrode (10) einen rückseitigen transparenten leitfähigen Materialstapel und eine metallische Kontaktschicht (15) aufweist, wobei der rückseitige transparente leitfähige Materialstapel ein Stapel aus wenigstens zwei transparenten leitfähigen Komponenten mit unterschiedlichen Zusammensetzungen ist, und wobei der rückseitige transparente leitfähige Materialstapel
- eine rückseitige erste transparente leitfähige Schicht (5'), die aus einem dritten Basismaterial mit einer dritten Dotierung besteht und eine nicht-stöchiometrische Zusammensetzung mit einer ersten Stöchiometrieabweichung hat, wobei das dritte Basismaterial aus einer Gruppe ausgewählt ist, welche Indiumoxid, Zinkoxid, Zinnoxid und Cadmiumoxid umfasst, und
- eine rückseitige zweite transparente leitfähige Schicht oder Struktur (6') aufweist, die aus einem dritten Basismaterial oder einem vierten Basismaterial besteht, wobei das dritte oder vierte Basismaterial eine dritte Dotierung oder eine vierte Dotierung hat, die sich von der dritten Dotierung unterscheidet und eine nicht-stöchiometrische Zusammensetzung hat, wobei die Zusammensetzung des vierten Basismaterials sich von der Zusammensetzung des dritten Basismaterials unterscheidet und wobei die Zusammensetzung des dritten Basismaterials eine vierte Stöchiometrieabweichung hat, die sich jeweils von der dritten Stöchiometrieabweichung unterscheidet,
wobei
die durchschnittliche Ladungsträgerkonzentration des gesamten rückseitigen transparenten leitfähigen Materialstapels zwischen 1 x 10²⁰ cm⁻³ und 2 x 10²⁰ cm⁻³ liegt;
die Brechungsindizes (n) der rückseitigen ersten transparenten leitfähigen Schicht (5') und der rückseitigen zweiten transparenten leitfähigen Schicht oder Struktur (6') in der gleichen Größenordnung liegen, wobei n > 2 bei einer Wellenlänge von etwa 550 nm ist; und
die Ladungsträgerbeweglichkeit in der rückseitigen ersten transparenten leitfähigen Schicht (5') höher als die Ladungsträgerbeweglichkeit in der rückseitigen zweiten transparenten leitfähigen Schicht oder Struktur (6') ist, wenn die Schichten/Struktur (5'; 6') eine vergleichbare Dicke haben.

3. Photovoltaikvorrichtung nach wenigstens einem der vorhergehenden Ansprüche, **dadurch gekennzeichnet, dass** die vorderseitige erste transparent leitfähige Schicht (5) auf dem Emitter (4) oder auf der Vorderseitenoberflächenfeldschicht ausgebildet ist, und/oder die rückseitige erste transparente leitfähige Schicht (5') auf der Rückseitenoberflächenfeldschicht (9) oder auf dem rückseitigen Emitter ausgebildet ist.

4. Photovoltaikvorrichtung nach wenigstens einem der vorhergehenden Ansprüche, **dadurch gekennzeichnet, dass** wenigstens ein Teil der zweiten transparenten leitfähigen Schicht oder Struktur (6, 6b; 6') auf der gesamten Oberfläche der Photovoltaikvorrichtung (1 a, 1 b, 1 c, 1 d, 1 e, 1f, 1 g, 1 h) ausgebildet ist.

5. Photovoltaikvorrichtung nach wenigstens einem der Ansprüche 1 bis 3, **dadurch gekennzeichnet, dass** wenigstens ein Teil der zweiten transparenten leitfähigen Schicht oder Struktur (6a) unter wenigstens Teilen der vorderseitigen Gittermetallisierung (7) angeordnet sind.

6. Photovoltaikvorrichtung nach wenigstens einem der vorhergehenden Ansprüche, **dadurch gekennzeichnet, dass** der transparente leitfähige Materialstapel desweiteren eine dritte transparente leitfähige Schicht (12) auf der Vorderseite der Photovoltaikvorrichtung (1 a, 1 b, 1 c, 1 d, 1 e, 1f, 1 g, 1 h, 1 g) zwischen dem Emitter (4) oder der Vorderseitenoberflächenfeldschicht und dem vorderseitigen transparenten leitfähigen Materialstapel (5, 6, 6a, 6b) und/oder auf einer Rückseite der Photovoltaikvorrichtung (1 a, 1 b, 1 c, 1 d, 1 e, 1 f, 1 g, 1 h) zwischen der Rückseitenoberflächenfeldschicht (9) oder dem rückseitigen Emitter und dem rückseitigen transparenten leitfähigen Materialstapel (5', 6') aufweist, wobei die dritte transparente leitfähige Schicht (12) eine Austrittsarbeit hat, die dann, wenn die Schicht (12) auf einem p-dotierten Emitter (4) oder einem rückseitigen Emitter oder einer Rückseitenoberflächenfeldschicht (9) oder einer Vorderseitenoberflächenfeldschicht aufgebracht ist, höher als die Austrittsarbeit der Schichten/Strukturen des transparenten leitfähigen Materialstapels (5, 6, 6a, 6b; 5', 6') ist, oder dann, wenn die Schicht (12) auf einem n-dotierten Emitter (4) oder rückseitigem Emitter oder einer Rückseitenoberflächenfeldschicht (9) oder Vorderseitenoberflächenfeldschicht aufgebracht ist, geringer als die Austrittsarbeit der Schichten/Strukturen des transparenten leitfähigen Materialstapels (5, 6, 6a, 6b; 5', 6') ist.

7. Photovoltaikvorrichtung nach wenigstens einem der vorhergehenden Ansprüche, **dadurch gekennzeichnet, dass** die zweite transparente leitfähige Schicht oder Struktur (6, 6a, 6b; 6') und/oder die dritte transparente leitfähige Schicht (12) aus wenigstens einem Material aus der Materialgruppe ausgewählt ist, welche Indiumoxid, Zinkoxid, Zinnoxid und Cadmiumoxid umfasst.

8. Photovoltaikvorrichtung nach wenigstens einem der vorhergehenden Ansprüche, **dadurch gekennzeichnet, dass** die vorderseitige zweite transparente leitfähige Schicht oder Struktur (6, 6a, 6b) mit einer zusätzlichen Antireflexionsschicht (11) beschichtet ist.

9. Photovoltaikvorrichtung nach Anspruch 8, **dadurch gekennzeichnet, dass** die zusätzliche Antireflexionsschicht (11) aus wenigstens einem Material aus der Materialgruppe ausgewählt ist, welche MgF₂, SiO₂, ZrO₂, TiO₂, CeF₃ und Al₂O₃ umfasst.

10. Verfahren zur Herstellung einer Photovoltaikvorrichtung (1 a, 1 b, 1 c, 1 d, 1 e, 1 f, 1 g, 1 h, 1 g) mit einem Heteroübergang, wobei die Photovoltaikvorrichtung mit einer Vorderseite (14) für einen Lichteinfall vorbereitet wird und das Verfahren die folgenden Schritte aufweist:
- Ausbilden eines kristallinen Halbleiterkörpers (2),
- Ausbilden einer Vorderseitenpassivierungsschicht (3), die auf einer vorderseitigen Oberfläche des kristallinen Halbleiterkörpers (2) vorgesehen ist,
- Ausbilden eines Emitters (4) oder einer Vorderseitenoberflächenfeldschicht, die auf der Vorderseitenpassivierungsschicht (3) vorgesehen ist,
- Bereitstellen eines vorderseitigen transparenten leitfähigen Materialstapels, und
- Ausbilden einer vorderseitigen Gittermetallisierung (7),
wobei
der vorderseitige transparente leitfähige Materialstapel durch Ausbilden eines Stapels aus wenigstens zwei transparenten leitfähigen Bauelementen aus verschiedenen Zusammensetzungen bereitgestellt wird,
wobei das Verfahren die folgenden Schritte aufweist:
- Ausbilden einer vorderseitigen ersten transparenten leitfähigen Schicht (5) auf dem Emitter (4), wobei die vorderseitige erste transparente leitfähige Schicht (5) unter Verwendung eines ersten Basismaterials, das eine erste Dotierung und eine nicht-stöchiometrische Zusammensetzung mit einer ersten Stöchiometrieabweichung hat, ausgebildet wird und wobei das erste Basismaterial aus der Materialgruppe ausgewählt wird, welche Indiumoxid, Zinkoxid, Zinnoxid und Cadmiumoxid umfasst, und
- Ausbilden einer vorderseitigen zweiten transparenten leitfähigen Schicht oder Struktur (6, 6a, 6b), wobei die vorderseitige zweite transparente leitfähige Struktur (6, 6a, 6b) unter Verwendung eines ersten Basismaterials oder eines zweiten Basismaterials ausgebildet wird, wobei das erste oder zweite Basismaterial eine erste Dotierung oder eine zweite Dotierung, welche sich von der ersten Dotierung unterscheidet, und eine nicht-stöchiometrische Zusammensetzung hat, wobei sich die Zusammensetzung des zweiten Basismaterials von der Zusammensetzung des ersten Basismaterials unterscheidet;
**dadurch gekennzeichnet**,
dass die Zusammensetzung des ersten Basismaterials der vorderseitigen zweiten transparenten leitfähigen Schicht oder Struktur (6, 6a, 6b) eine zweite Stöchiometrieabweichung hat, welche sich jeweils von der ersten Stöchiometrieabweichung unterscheidet,
wobei
die durchschnittliche Ladungsträgerkonzentration des gesamten vorderseitigen transparenten leitfähigen Materialstapels zwischen 1 x 10²⁰ cm⁻³ und 2 x 10²⁰ cm⁻³ liegt;
die Brechungsindizes (n) der vorderseitigen ersten transparenten leitfähigen Schicht (5) und der vorderseitigen zweiten transparenten leitfähigen Schicht oder Struktur (6, 6a, 6b) in der gleichen Größenordnung liegen, wobei n > 2 bei einer Wellenlänge von etwa 550 nm ist; und
die Ladungsträgerbeweglichkeit in der vorderseitigen ersten transparenten leitfähigen Schicht (5) höher als die Ladungsträgerbeweglichkeit in der vorderseitigen zweiten transparenten leitfähigen Schicht oder Struktur (6, 6a, 6b) ist, wenn die Schichten/Struktur (5; 6, 6a, 6b) eine vergleichbare Dicke haben.

11. Verfahren nach Anspruch 10, **dadurch gekennzeichnet, dass** das Verfahren weiterhin die Schritte aufweist:
- Ausbilden einer Rückseitenpassivierungsschicht (8) auf einer Rückseitenoberfläche des kristallinen Halbleiterkörpers (2),
- Ausbilden einer Rückseitenoberflächenfeldschicht (9) oder eines rückseitigen Emitters (4) auf der Rückseitenpassivierungsschicht (8),
- Ausbilden einer Rückseitenelektrode (10) auf der Rückseitenoberflächenfeldschicht (9) oder auf dem rückseitigen Emitter, und
- Bereitstellen einer Rückseitenelektrode (10) auf der Rückseitenoberflächenfeldschicht (9) durch Ausbilden eines rückseitigen transparenten leitfähigen Materialstapels und einer metallischen Kontaktschicht (15), wobei der rückseitige transparente leitfähige Materialstapel durch Ausbilden eines Stapels aus wenigstens zwei transparenten leitfähigen Komponenten mit unterschiedlichen Zusammensetzungen bereitgestellt wird, wobei die Schritte enthalten sind:
- Ausbilden einer rückseitigen ersten transparenten leitfähigen Schicht (5'), wobei die rückseitige erste transparente leitfähige Schicht (5') unter Verwendung eines dritten Basismaterials mit einer dritten Dotierung und einer nichtstöchiometrischen Zusammensetzung mit einer ersten Stöchiometrieabweichung ausgebildet wird, und wobei das dritte Basismaterial aus einer Gruppe ausgewählt wird, welche Indiumoxid, Zinkoxid, Zinnoxid und Cadmiumoxid umfasst, und
- Ausbilden einer rückseitigen zweiten transparenten leitfähigen Schicht oder Struktur (6'), wobei die rückseitige zweite transparente leitfähige Schicht oder Struktur (6') durch die Verwendung eines dritten Basismaterials oder eines vierten Basismaterial ausgebildet wird, wobei das dritte oder vierte Basismaterial eine dritte Dotierung oder eine vierte Dotierung, die sich von der dritten Dotierung unterscheidet, und eine nicht-stöchiometrische Zusammensetzung hat, wobei die Zusammensetzung des vierten Basismaterials sich von der Zusammensetzung des dritten Basismaterials unterscheidet und wobei die Zusammensetzung des dritten Basismaterials eine vierte Stöchiometrieabweichung hat, die sich jeweils von der dritten Stöchiometrieabweichung unterscheidet,
wobei die durchschnittliche Ladungsträgerkonzentration des gesamten rückseitigen transparenten leitfähigen Materialstapels zwischen 1 x 10²⁰ cm⁻³ und 2 x 10²⁰ cm⁻³ liegt;
die Brechungsindizes (n) der rückseitigen ersten transparenten leitfähigen Schicht (5') und der rückseitigen zweiten transparent leitfähigen Schicht oder Struktur (6') in der gleichen Größenordnung liegen, wobei n > 2 bei einer Wellenlänge von etwa 550 nm ist; und
die Ladungsträgerbeweglichkeit in der rückseitigen ersten transparenten leitfähigen Schicht (5') höher als die Ladungsträgerbeweglichkeit in der rückseitigen zweiten transparenten leitfähigen Schicht oder Struktur (6') ist, wenn die Schichten/Struktur (5'; 6') eine vergleichbare Dicke haben.

12. Verfahren nach Anspruch 10 oder 11, **dadurch gekennzeichnet, dass** die zweite transparente leitfähige Struktur (6a, 6b) als eine Schicht auf der gesamten Oberfläche der ersten transparenten leitfähigen Schicht (5) oder auf der gesamten Oberfläche des Emitters (4) oder auf der gesamten Vorderseitenoberflächenfeldschicht ausgebildet und durch Ätzen strukturiert wird, wobei die vorderseitige Gittermetallisierung (7) während des Ätzprozesses als Maske fungiert.

13. Verfahren nach wenigstens einem der Ansprüche 10 oder 12, **dadurch gekennzeichnet, dass** das Material der zweiten transparenten leitfähigen Struktur (6a, 6b) als eine Schicht auf der gesamten Oberfläche der ersten transparenten leitfähigen Schicht (5) oder auf der gesamten Oberfläche des Emitters (4) oder auf der gesamten Vorderseitenoberflächenfeldschicht abgeschieden und durch Ätzen strukturiert wird, und die vorderseitige Gittermetallisierung (7) auf der strukturierten zweiten transparenten leitfähigen Schicht oder Struktur (6a, 6b) ausgerichtet wird.

14. Verfahren nach wenigstens einem der Ansprüche 10 bis 13, **dadurch gekennzeichnet, dass** die zweite transparente leitfähige Schicht oder Struktur (6a) durch eine Maske auf der ersten transparenten leitfähigen Schicht (5) oder auf dem Emitter (4) oder auf der Vorderseitenoberflächenfeldschicht abgeschieden wird, und die vorderseitige Gittermetallisierung (7) auf der strukturierten zweiten transparenten leitfähigen Struktur (6a) ausgerichtet wird.

15. Verfahren nach einem der Ansprüche 10 bis 14, **dadurch gekennzeichnet, dass** eine dritte transparente leitfähige Schicht (12) zwischen dem Emitter (4) oder der Vorderseitenoberflächenfeldschicht und dem vorderseitigen transparenten leitfähigen Materialstapel (5, 6, 6a, 6b) auf der Vorderseite der Photovoltaikvorrichtung (1 a, 1 b, 1 c, 1 d, 1 e, 1f, 1 g, 1 h) und/oder zwischen der Rückseitenoberflächenfeldschicht (9) und dem rückseitigen transparenten leitfähigen Materialstapel (5', 6') auf der Rückseite der Photovoltaikvorrichtung (1 a, 1 b, 1 c, 1 d, 1 e, 1f, 1 g, 1 h) ausgebildet wird, wobei die dritte transparente leitfähige Schicht (12) dann, wenn sie auf einem p-dotierten Emitter (4) oder einem rückseitigen Emitter oder einer Rückseitenoberflächenfeldschicht (9) oder einer Vorderseitenoberflächenfeldschicht aufgebracht wird, eine höhere Austrittsarbeit als die Austrittsarbeit der Schichten/Strukturen des transparenten leitfähigen Materialstapels (5, 6, 6a, 6b; 5', 6') hat oder dann, wenn sie auf einem n-dotierten Emitter (4) oder rückseitigem Emitter oder einer Rückseitenoberflächenfeldschicht (9) oder einer Vorderseitenoberflächenfeldschicht aufgebracht wird, eine geringere Austrittsarbeit als die Austrittsarbeit der Schichten/Strukturen des transparenten leitfähigen Materialstapels (5, 6, 6a, 6b; 5', 6') hat.

16. Verfahren nach einem der Ansprüche 10 bis 15, **dadurch gekennzeichnet, dass** die Verfahrensschritte in der folgenden Reihenfolge vorgesehen sind:
- Ausbilden des Emitters (4) oder der Vorderseitenoberflächenfeldschicht,
- Ausbilden der vorderseitigen ersten transparenten leitfähigen Schicht oder Struktur (5) auf dem Emitter (4) oder der Vorderseitenoberflächenfeldschicht,
- Ausbilden der vorderseitigen zweiten transparenten leitfähigen Schicht (6, 6a, 6b) auf der vorderseitigen ersten transparenten leitfähigen Schicht oder Struktur (5), und
- Ausbilden der vorderseitigen Gittermetallisierung (7) auf der Oberseite der vorderseitigen zweiten transparenten leitfähigen Schicht oder Struktur (6, 6a, 6b).

17. Verfahren nach einem der Ansprüche 10 bis 15, **dadurch gekennzeichnet, dass** die Verfahrensschritte in der folgenden Reihenfolge vorgesehen sind:
- Ausbilden des Emitters (4) oder der Vorderseitenoberflächenfeldschicht,
- Ausbilden der vorderseitigen zweiten transparenten leitfähigen Schicht oder Struktur (6, 6a, 6b) auf dem Emitter (4) oder auf der Vorderseitenoberflächenfeldschicht,
- Ausbilden der vorderseitigen Gittermetallisierung (7) auf der Oberseite der vorderseitigen zweiten transparenten leitfähigen Schicht oder Struktur (6, 6a, 6b), und
- Ausbilden der vorderseitigen ersten transparenten leitfähigen Schicht (5) auf der vorderseitigen Gittermetallisierung (7).

18. Verfahren nach einem der Ansprüche 10 bis 17, **dadurch gekennzeichnet, dass** der vorderseitige transparente leitfähige Materialstapel mit einer zusätzlichen Antireflexionsschicht (11) beschichtet wird, und Kontakte der vorderseitigen Gittermetallisierung (7) durch eine Maske oder durch eine lösliche Druckfarbe, welche jeweils auf den Kontakten vorgesehen ist, während des Ausbildens der zusätzlichen Antireflexionsschicht (11) geschützt werden.

## Revendications

1. Dispositif photovoltaïque (1 a, 1 b, 1 c, 1 d, 1 e, 1f, 1 g, 1 h, 1 g) doté d'une hétérojonction, ledit dispositif photovoltaïque ayant un côté avant (14) pour une incidence de lumière et comprenant
- un corps semi-conducteur cristallin (2),
- une couche de passivation avant (3) formée sur une surface avant du corps semi-conducteur cristallin (2),
- un émetteur (4) ou une couche de champ de surface avant formé(e) sur la couche de passivation avant (3),
- un empilement de matériaux conducteurs transparents côté avant, et
- une métallisation de grille avant (7),
dans lequel
l'empilement de matériaux conducteurs transparents côté avant est un empilement d'au moins deux composants conducteurs transparents ayant des compositions différentes, dans lequel l'empilement de matériaux conducteurs transparents côté avant comprend
- une première couche conductrice transparente côté avant (5) constituée d'un premier matériau de base avec un premier dopage et ayant une composition non stoechiométrique avec un premier écart de stoechiométrie, dans lequel le premier matériau de base est choisi dans le groupe de matériaux incluant l'oxyde d'indium, l'oxyde de zinc, l'oxyde d'étain et l'oxyde de cadmium, et
- une deuxième couche ou structure conductrice transparente côté avant (6, 6a, 6b) constituée du premier matériau de base ou d'un deuxième matériau de base, ledit premier ou deuxième matériau de base ayant le premier dopage ou un deuxième dopage différent du premier dopage et ayant une composition non stoechiométrique, dans lequel la composition du deuxième matériau de base est différente de la composition du premier matériau de base ;
**caractérisé en ce que** la composition du premier matériau de base de ladite deuxième couche ou structure conductrice transparente côté avant (6, 6a, 6b) a un deuxième écart de stoechiométrie différent du premier écart de stoechiométrie, respectivement,
et dans lequel
la concentration de porteurs moyenne de la totalité de l'empilement de matériaux conducteurs transparents côté avant est entre 1 x 10²⁰ cm⁻³ et 2 x 10²⁰ cm⁻³ ;
les indices de réfraction (n) de la première couche conductrice transparente côté avant (5) et de la deuxième couche ou structure conductrice transparente côté avant (6, 6a, 6b) sont dans la même plage, dans lequel n > 2 à une longueur d'onde d'environ 550 nm ; et
la mobilité de porteurs dans la première couche conductrice transparente côté avant (5) est plus élevée que la mobilité de porteurs dans la deuxième couche ou structure conductrice transparente côté avant (6, 6a, 6b) si les couches/la structure (5 ; 6, 6a, 6b) ont une épaisseur comparable.

2. Dispositif photovoltaïque selon la revendication 1, **caractérisé en ce qu'**une couche de passivation arrière (8) est formée sur une surface arrière du corps semi-conducteur cristallin (2), une couche de champ de surface arrière (9) ou un émetteur côté arrière est formé(e) sur la couche de passivation arrière (8), une électrode arrière (10) est formée sur la couche de champ de surface arrière (9) ou sur l'émetteur côté arrière, dans lequel l'électrode arrière (10) comprend un empilement de matériaux conducteurs transparents côté arrière et une couche de contact métallique (15), dans lequel l'empilement de matériaux conducteurs transparents côté arrière est un empilement d'au moins deux composants conducteurs transparents ayant des compositions différentes, et dans lequel l'empilement de matériaux conducteurs transparents côté arrière comprend
- une première couche conductrice transparente côté arrière (5') constituée d'un troisième matériau de base avec un troisième dopage et ayant une composition non stoechiométrique avec un premier écart de stoechiométrie, dans lequel le troisième matériau de base est choisi dans le groupe incluant l'oxyde d'indium, l'oxyde de zinc, l'oxyde d'étain et l'oxyde de cadmium, et
- une deuxième couche ou structure conductrice transparente côté arrière (6') constituée du troisième matériau de base ou d'un quatrième matériau de base, ledit troisième ou quatrième matériau de base ayant le troisième dopage ou un quatrième dopage différent du troisième dopage et ayant une composition non stoechiométrique, dans lequel la composition du quatrième matériau de base est différente de la composition du troisième matériau de base et dans lequel la composition du troisième matériau de base a un quatrième écart de stoechiométrie différent du troisième écart de stoechiométrie, respectivement,
dans lequel
la concentration de porteurs moyenne de la totalité de l'empilement de matériaux conducteurs transparents côté arrière est entre 1 x 10²⁰ cm⁻³ et 2 x 10²⁰ cm⁻³ ;
les indices de réfraction (n) de la première couche conductrice transparente côté arrière (5') et de la deuxième couche ou structure conductrice transparente côté arrière (6') sont dans la même plage, dans lequel n > 2 à une longueur d'onde d'environ 550 nm ; et
la mobilité de porteurs dans la première couche conductrice transparente côté arrière (5') est plus élevée que la mobilité de porteurs dans la deuxième couche ou structure conductrice transparente côté arrière (6') si les couches/la structure (5' ; 6') ont une épaisseur comparable.

3. Dispositif photovoltaïque selon au moins l'une des revendications précédentes, **caractérisé en ce que** la première couche conductrice transparente côté avant (5) est formée sur l'émetteur (4) ou sur la couche de champ de surface avant, et/ou la première couche conductrice transparente côté arrière (5') est formée sur la couche de champ de surface arrière (9) ou sur l'émetteur côté arrière.

4. Dispositif photovoltaïque selon au moins l'une des revendications précédentes, **caractérisé en ce qu'**au moins une partie de la deuxième couche ou structure conductrice transparente (6, 6b ; 6') est formée sur la totalité de la surface du dispositif photovoltaïque (1a, 1b, 1c, 1d, 1e, 1f, 1 g, 1h).

5. Dispositif photovoltaïque selon au moins l'une des revendications 1 à 3, **caractérisé en ce qu'**au moins une partie de la deuxième couche ou structure conductrice transparente (6a) est localisée au moins sous des parties de la métallisation de grille avant (7).

6. Dispositif photovoltaïque selon au moins l'une des revendications précédentes, **caractérisé en ce que** l'empilement de matériaux conducteurs transparents comprend en outre une troisième couche conductrice transparente (12) formée sur le côté avant du dispositif photovoltaïque (1 a, 1 b, 1 c, 1 d, 1 e, 1 f, 1 g, 1 h, 1g) entre l'émetteur (4) ou la couche de champ de surface avant et l'empilement de matériaux conducteurs transparents côté avant (5, 6, 6a, 6b) et/ou formée sur un côté arrière du dispositif photovoltaïque (1a, 1b, 1c, 1 d, 1e, 1 f, 1 g, 1h) entre la couche de champ de surface arrière (9) ou l'émetteur côté arrière et l'empilement de matériaux conducteurs transparents côté arrière (5', 6'), dans lequel la troisième couche conductrice transparente (12) a un travail d'extraction plus élevé si elle est mise sur un émetteur à dopage p (4) ou un émetteur côté arrière ou une couche de champ de surface arrière (9) ou une couche de champ de surface avant que le travail d'extraction des couches/structures de l'empilement de matériaux conducteurs transparents (5, 6, 6a, 6b ; 5', 6') ou moins élevé si elle est mise sur un émetteur à dopage n (4) ou un émetteur côté arrière ou une couche de champ de surface arrière (9) ou une couche de champ de surface avant que le travail d'extraction des couches/structures de l'empilement de matériaux conducteurs transparents (5, 6, 6a, 6b ; 5', 6').

7. Dispositif photovoltaïque selon au moins l'une des revendications précédentes, **caractérisé en ce que** la deuxième couche ou structure conductrice transparente (6, 6a, 6b ; 6') et/ou la troisième couche conductrice transparente (12) est/sont constituée(s) d'au moins un matériau choisi dans le groupe de matériaux incluant l'oxyde d'indium, l'oxyde de zinc, l'oxyde d'étain et l'oxyde de cadmium.

8. Dispositif photovoltaïque selon au moins l'une des revendications précédentes, **caractérisé en ce que** la deuxième couche ou structure conductrice transparente côté avant (6, 6a, 6b) est recouverte d'un revêtement antireflet supplémentaire (11).

9. Dispositif photovoltaïque selon la revendication 8, **caractérisé en ce que** le revêtement antireflet supplémentaire (11) est constitué d'au moins un matériau choisi dans le groupe de matériaux incluant MgF₂, SiO₂, ZrO₂, TiO₂, CeF₃ et Al₂O₃.

10. Procédé de fabrication d'un dispositif photovoltaïque (1a, 1b, 1c, 1 d, 1e, 1 f, 1 g, 1h, 1g) doté d'une hétérojonction, ledit dispositif photovoltaïque étant préparé avec un côté avant (14) pour une incidence de lumière, dans lequel le procédé comprend les étapes de
- fourniture d'un corps semi-conducteur cristallin (2),
- formation d'une couche de passivation avant (3) sur le corps semi-conducteur cristallin (2),
- formation d'un émetteur (4) ou d'une couche de champ de surface avant sur la couche de passivation avant (3),
- fourniture d'un empilement de matériaux conducteurs transparents côté avant, et
- formation d'une métallisation de grille avant (7),
dans lequel
l'empilement de matériaux conducteurs transparents côté avant est fourni en formant un empilement d'au moins deux composants conducteurs transparents ayant des compositions différentes, comprenant les étapes de
- formation d'une première couche conductrice transparente côté avant (5) sur l'émetteur (4), dans lequel la première couche conductrice transparente côté avant (5) est formée à l'aide d'un premier matériau de base avec un premier dopage et ayant une composition non stoechiométrique avec un premier écart de stoechiométrie, et dans lequel le premier matériau de base est choisi dans le groupe de matériaux incluant l'oxyde d'indium, l'oxyde de zinc, l'oxyde d'étain et l'oxyde de cadmium, et
- formation d'une deuxième couche ou structure conductrice transparente côté avant (6, 6a, 6b), dans lequel la deuxième structure conductrice transparente côté avant (6, 6a, 6b) est formée à l'aide du premier matériau de base ou d'un deuxième matériau de base, ledit premier ou deuxième matériau de base ayant le premier dopage ou un deuxième dopage différent du premier dopage et ayant une composition non stoechiométrique, dans lequel la composition du deuxième matériau de base est différente de la composition du premier matériau de base ;
**caractérisé en ce que** la composition du premier matériau de base de ladite deuxième couche ou structure conductrice transparente côté avant (6, 6a, 6b) a un deuxième écart de stoechiométrie différent du premier écart de stoechiométrie, respectivement,
dans lequel
la concentration de porteurs moyenne de la totalité de l'empilement de matériaux conducteurs transparents côté avant est entre 1 x 10²⁰ cm⁻³ et 2 x 10²⁰ cm⁻³ ;
les indices de réfraction (n) de la première couche conductrice transparente côté avant (5) et de la deuxième couche ou structure conductrice transparente côté avant (6, 6a, 6b) sont dans la même plage, dans lequel n > 2 à une longueur d'onde d'environ 550 nm ; et
la mobilité de porteurs dans la première couche conductrice transparente côté avant (5) est plus élevée que la mobilité de porteurs dans la deuxième couche ou structure conductrice transparente côté avant (6, 6a, 6b) si les couches/la structure (5 ; 6, 6a, 6b) ont une épaisseur comparable.

11. Procédé selon la revendication 10, **caractérisé en ce que** le procédé comprend en outre les étapes de
- formation d'une couche de passivation arrière (8) sur une surface arrière du corps semi-conducteur cristallin (2),
- formation d'une couche de champ de surface arrière (9) ou d'un émetteur côté arrière sur la couche de passivation arrière (8),
- formation d'une couche de contact métallique (10) sur la couche de champ de surface (9) ou sur l'émetteur côté arrière, et
- fourniture d'une électrode arrière (10) sur la couche de champ de surface arrière (9) en formant un empilement de matériaux conducteurs transparents côté arrière et en formant une couche de contact métallique (15), dans lequel l'empilement de matériaux conducteurs transparents côté arrière est fourni en formant un empilement d'au moins deux composants conducteurs transparents ayant des compositions différentes, comprenant les étapes de
- formation d'une première couche conductrice transparente côté arrière (5'), dans lequel la première couche conductrice transparente côté arrière (5') est formée à l'aide d'un troisième matériau de base avec un troisième dopage et ayant une composition non stoechiométrique avec un troisième écart de stoechiométrie, et dans lequel le troisième matériau de base est choisi dans le groupe de matériaux incluant l'oxyde d'indium, l'oxyde de zinc, l'oxyde d'étain et l'oxyde de cadmium, et
- formation d'une deuxième couche ou structure conductrice transparente côté arrière (6'), dans lequel la deuxième structure conductrice transparente côté arrière (6') est formée à l'aide du troisième matériau de base ou d'un quatrième matériau de base, ledit troisième ou quatrième matériau de base ayant le troisième dopage ou un quatrième dopage différent du troisième dopage et ayant une composition non stoechiométrique, dans lequel la composition du quatrième matériau de base est différente de la composition du troisième matériau de base et dans lequel la composition du troisième matériau de base a un quatrième écart de stoechiométrie différent du troisième écart de stoechiométrie, respectivement,
dans lequel
la concentration de porteurs moyenne de la totalité de l'empilement de matériaux conducteurs transparents côté arrière est entre 1 x 10²⁰ cm⁻³ et 2 x 10²⁰ cm⁻³ ;
les indices de réfraction (n) de la première couche conductrice transparente côté arrière (5') et de la deuxième couche ou structure conductrice transparente côté arrière (6') sont dans la même plage, dans lequel n > 2 à une longueur d'onde d'environ 550 nm ; et
la mobilité de porteurs dans la première couche conductrice transparente côté arrière (5') est plus élevée que la mobilité de porteurs dans la deuxième couche ou structure conductrice transparente côté arrière (6') si les couches/la structure (5' ; 6') ont une épaisseur comparable.

12. Procédé selon la revendication 10 ou 11, **caractérisé en ce que** la deuxième structure conductrice transparente (6a, 6b) est formée sous forme de couche sur la totalité de la surface de la première couche conductrice transparente (5) ou sur la totalité de la surface de l'émetteur (4) ou sur la totalité de la couche de champ de surface avant et est structurée par gravure, dans lequel la métallisation de grille avant (7) sert de masque pendant le processus de gravure.

13. Procédé selon au moins l'une des revendications 10 ou 12, **caractérisé en ce que** le matériau de la deuxième structure conductrice transparente (6a, 6b) est déposé sous forme de couche sur la totalité de la surface de la première couche conductrice transparente (5) ou sur la totalité de la surface de l'émetteur (4) ou sur la totalité de la couche de champ de surface avant et est structuré par gravure, et la métallisation de grille avant (7) est alignée sur la deuxième couche ou structure conductrice transparente structurée (6a, 6b).

14. Procédé selon au moins l'une des revendications 10 à 13, **caractérisé en ce que** la deuxième couche ou structure conductrice transparente (6a) est déposée par l'intermédiaire d'un masque sur la première couche conductrice transparente (5) ou sur l'émetteur (4) ou sur la couche de champ de surface avant, et la métallisation de grille avant (7) est alignée sur la deuxième structure conductrice transparente localisée (6a).

15. Procédé selon l'une des revendications 10 à 14, **caractérisé en ce qu'**une troisième couche conductrice transparente (12) est formée entre l'émetteur (4) ou la couche de champ de surface avant et l'empilement de matériaux conducteurs transparents (5, 6, 6a, 6b) sur le côté avant du dispositif photovoltaïque (1a, 1b, 1c, 1 d, 1e, 1f, 1 g, 1h) et/ou entre la couche de champ de surface arrière (9) ou l'émetteur côté arrière et l'empilement de matériaux conducteurs transparents (5', 6') sur le côté arrière du dispositif photovoltaïque (1 a, 1 b, 1 c, 1 d, 1 e, 1 f, 1 g, 1 h), dans lequel la troisième couche conductrice transparente (12) a un travail d'extraction plus élevé si elle est mise sur un émetteur à dopage p (4) ou un émetteur côté arrière ou une couche de champ de surface arrière (9) ou une couche de champ de surface avant que le travail d'extraction des couches/structures de l'empilement de matériaux conducteurs transparents (5, 6, 6a, 6b ; 5', 6') ou inférieur si elle est mise sur un émetteur à dopage n (4) ou un émetteur côté arrière ou une couche de champ de surface arrière (9) ou une couche de champ de surface avant que le travail d'extraction des couches/structures de l'empilement de matériaux conducteurs transparents (5, 6, 6a, 6b ; 5', 6').

16. Procédé selon l'une des revendications 10 à 15, **caractérisé en ce que** les étapes du procédé sont fournies dans l'ordre suivant
- formation de l'émetteur (4) ou sur la couche de champ de surface avant,
- formation de la première couche ou structure conductrice transparente côté avant (5) sur l'émetteur (4) ou la couche de champ de surface avant,
- formation de la deuxième couche conductrice transparente côté avant (6, 6a, 6b) sur la première couche ou structure conductrice transparente côté avant (5), et
- formation de la métallisation de grille avant (7) au-dessus de la deuxième couche ou structure conductrice transparente côté avant (6, 6a, 6b).

17. Procédé selon l'une des revendications 10 à 15, **caractérisé en ce que** les étapes du procédé sont fournies dans l'ordre suivant
- formation de l'émetteur (4) ou de la couche de champ de surface avant,
- formation de la deuxième couche ou structure conductrice transparente côté avant (6, 6a, 6b) sur l'émetteur (4) ou sur la couche de champ de surface avant,
- formation de la métallisation de grille avant (7) au-dessus de la deuxième couche ou structure conductrice transparente côté avant (6, 6a, 6b), et
- formation de la première couche conductrice transparente côté avant (5) sur la métallisation de grille avant (7).

18. Procédé selon l'une des revendications 10 à 17, **caractérisé en ce que** l'empilement de matériaux conducteurs transparents côté avant est recouvert d'un revêtement antireflet supplémentaire (11), et des contacts de la métallisation de grille avant (7) sont protégés par un masque ou par une encre soluble fournie sur les contacts, respectivement, pendant la formation du revêtement antireflet supplémentaire (11).
